# EUROPEAN PATENT APPLICATION

(11) **EP 4 592 299 A1**
(43) Date of publication of application: **30.07.2025**
(21) Application number: 25150778.6
(22) Date of filing: 08.01.2025
(51) Int. Cl.: C07F 7/08, C09D 183/04, G03F 7/004, H01L 21/027

(54) **SILICON-CONTAINING SULFONIUM SALT COMPOUND, COMPOSITION FOR FORMING A SILICON-CONTAINING RESIST UNDERLAYER FILM, AND PATTERNING PROCESS**

(30) Priority: 23.01.2024 JP 2024008202
(71) Applicant: SHIN-ETSU CHEMICAL CO., LTD., Tokyo 1000005 (JP)
(72) Inventor: Sawamura, Takashi, Niigata (JP); Mitsui, Ryo, Niigata (JP)
(74) Representative: Sonnenhauser, Thomas Martin

(57) **Abstract**

The present invention is a silicon-containing sulfonium salt compound represented by the following general formula (A-1). The present invention provides:
a composition for forming a silicon-containing resist underlayer film capable of forming a silicon-containing resist underlayer film that has an appropriate etching rate in multilayer resist method and can improve LWR and CDU of an ultrafine pattern; a silicon-containing sulfonium salt compound contained in the composition;
and a patterning process using the composition.

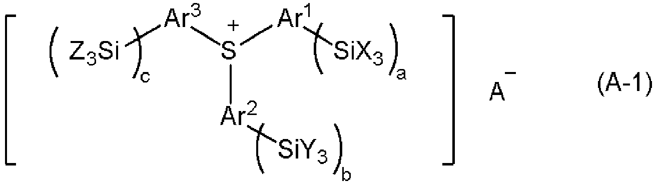

## Description

### TECHNICAL FIELD

The present invention relates to a silicon-containing sulfonium salt compound, a composition for forming a silicon-containing resist underlayer film containing the compound, and a patterning process using the composition.

### BACKGROUND ART

As higher integration and higher speed of LSI have been achieved, the pattern size has been rapidly miniaturized. With this miniaturization, lithography techniques have achieved formation of the fine pattern by shortening a wavelength of a light source and appropriate selecting a resist composition corresponding to the wavelength. The center of the resist composition is a positive-type photoresist composition used for a single layer. This single-layer positive-type photoresist composition has a skeleton having etching resistance against dry etching with chlorine-type or fluorine-type gas plasma in a resist resin, and has a switching mechanism so that an exposed portion is dissolved to form a pattern. While using the remained resist pattern as an etching mask, a substrate to be processed is processed by dry etching.

However, miniaturing the pattern, that is reducing the pattern width, with keeping a thickness of the used photoresist film causes a problem of deteriorating resolution performance of the photoresist film. In addition, pattern-developing such a photoresist film, which has an excessively high "aspect ratio", with a developer consequently causes a problem of pattern collapse. Thus, the photoresist film has been thinned as the pattern has been miniaturized.

Meanwhile, commonly used for processing a substrate to be processed is a method of processing the substrate by dry etching while using a patterned photoresist film having a formed pattern as an etching mask. However, there is realistically no dry etching method that can have complete etching selectivity between the photoresist film and the substrate to be processed. Thus, there is a problem of collapse of the resist film with damaged during the substrate processing to fail to accurately transfer the photoresist pattern to the substrate to be processed. Accordingly, as the pattern has been miniaturized, the photoresist composition is required to have higher dry-etching resistance. However, on the other hand, a resin used for the photoresist composition is required to have small light absorption at the exposure wavelength to improve the resolution. Thus, as the wavelength of the exposure light has become shorter to i-line, KrF, and ArF, the resin used for the photoresist composition has also changed to a novolac resin, polyhydroxystyrene, and a resin having an aliphatic polycyclic skeleton. However, the etching rate under the dry etching condition during the substrate processing has become realistically high, and recent photoresist compositions having high resolution rather tend to have weak etching resistance.

Thus, the substrate to be processed is necessarily processed by dry etching with the photoresist film having a smaller thickness and weaker etching resistance. It is urgently necessary to achieve a material and process for this processing.

One of methods to solve such a problem is a multilayer resist method. This method is of: interposing a resist underlayer film having etching selectivity different from etching selectivity of a photoresist film (that is, a resist upper layer film) between the resist upper layer film and a substrate to be processed; obtaining a pattern in the resist upper layer film; then transferring the pattern to the resist underlayer film by dry etching while using the resist upper layer film pattern as a dry etching mask; and further transferring the pattern to the substrate to be processed by dry etching while using the resist underlayer film as a dry etching mask.

One of the multilayer resist methods is a three-layer resist method that can be performed by using a common resist composition used for the single-layer resist method. In this three-layer resist method, for example, an organic film of a novolac resin, etc. is formed on a substrate to be processed as a resist underlayer film, a silicon-containing resist middle layer film is formed thereon, and a common organic photoresist film is formed thereon as a resist upper layer film. The organic resist upper layer film can have good etching selectivity to the silicon-containing resist middle layer film when the dry etching is performed with fluorine-based gas plasma. Thus, the resist upper layer film pattern can be transferred to the silicon-containing resist middle layer film by dry etching with the fluorine-based gas plasma. According to this method, the pattern can be transferred to the silicon-containing resist middle layer film even by using a resist composition that is difficult to form a pattern having a film thickness sufficient for directly processing the substrate to be processed or by using a resist composition that has dry etching resistance insufficient for processing the substrate. Subsequently transferring the pattern by dry etching with oxygen-based or hydrogen-based gas plasma can yield an organic film pattern of the novolac resin, etc. that has dry etching resistance sufficient for processing the substrate. A remained silicon-containing resist middle layer film after forming the organic film pattern is commonly removed so as not to be a residue to cause a defect by dry etching with fluorine-based gas plasma or by wet-etching with an etching liquid such as an alkaline etching liquid and a fluorine-based etching liquid. An insufficient etching rate increases possibility of problems such as remaining a residue derived from the silicon-containing middle layer film to cause a defect and requiring a long-time etching treatment to damage the substrate to be processed. As above, the silicon-containing resist middle layer film is needed to have an appropriate etching rate for precise patterning and smooth removal.

Meanwhile, in recent years, with emerging of ArF immersion lithography, EUV lithography, etc., formation of finer patterns is becoming possible, and along with it the photoresist film is becoming thinner further. Such thinning of the photoresist film causes deterioration in edge roughness (LWR) and dimension uniformity (CDU) of a hole pattern in ultrafine pattern, and thus improvement of LWR and CDU has become a serious problem.

Here, a composition for forming a silicon-containing resist middle layer film for ArF or EUV lithography containing a curing catalyst has been proposed (Patent Documents 1 and 2). This curing catalyst has a structure suitable for catalyzing the condensation reaction of silanol and promoting the formation of a siloxane bond that serves as the main skeleton of the silicon-containing resist middle layer film. It is also becoming clear that choice of a curing catalyst has a variety of effects on properties of a silicon-containing resist middle layer film. Examples thereof include acidity/basicity, hydrophilicity/hydrophobicity, hardness, film density, etching rate. These curing catalysts have a structure similar to a sensitivity modifier in the upper resist. Therefore, when diffusion into the upper resist layer occurs due to heating or light exposure, there is a problem in that it greatly affects the pattern forming ability of the photoresist. In particular, because it affects the performance of LWR and CDU, there is a need to develop a curing catalyst of which diffusion into the upper resist layer can be suppressed.

On the other hand, a photosensitive upper layer resist material is known in which a compound having a cation and an anion in its molecule is added in order to improve LWR and CDU (Patent Document 3). However, in recent ultrafine patterns, more high precision LWR and CDU are required, and performance improvement of silicon-containing resist middle layer films is also required.

### CITATION LIST

### PATENT LITERATURE

Patent Document 1: JP2007-302873A
Patent Document 2: WO2013/161372A1
Patent Document 3: JP2011-016746A

### SUMMARY OF INVENTION

### TECHNICAL PROBLEM

An object of the present invention is to provide: a composition for forming a silicon-containing resist underlayer film capable of forming a silicon-containing resist underlayer film that has an appropriate etching rate in multilayer resist method and can improve LWR and CDU of an ultrafine pattern; a silicon-containing sulfonium salt compound contained in the composition; and a patterning process using the composition.

### SOLUTION TO PROBLEM

To solve the above problems, the present invention provides a silicon-containing sulfonium salt compound represented by the following general formula (A-1), 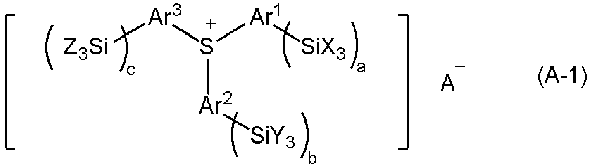 wherein, Ar¹, Ar², and Ar³ are each independently an aromatic group having 6 to 20 carbon atoms and optionally containing a substituent, or a heteroaromatic group having 4 to 20 carbon atoms and optionally containing a substituent, and any two or more selected from the group consisting of Ar¹, Ar², and Ar³ may be bonded with each other to form a ring together with a sulfur atom in the formula; "a", "b", and "c" each independently are integer of 0 to 3 and satisfy 1≤a+b+c≤9; X, Y, and Z represent a monovalent organic group having 1 to 14 carbon atoms, and may be the same or different from each other; and A⁻ represents an organic or inorganic anion that serves as a counter ion of a sulfonium cation.

When such a silicon-containing sulfonium salt compound is added to a composition for forming a silicon-containing resist underlayer film, it functions as a curing catalyst, and its heat-curing can be accelerated. Furthermore, because the inventive silicon-containing sulfonium salt compound has high affinity with silicon polymers, adding the inventive compound to a composition for forming a silicon-containing resist underlayer film suppresses diffusion of the inventive compound into the upper resist layer, and it is possible to form a silicon-containing resist underlayer film having good LWR and CDU. Furthermore, due to an effect of the silicon atom, it is possible to form a silicon-containing resist underlayer film having a good etching rate.

Further, the present invention provides a composition for forming a silicon-containing resist underlayer film, comprising; the silicon-containing sulfonium salt compound according to the above; and a thermally crosslinkable polysiloxane.

With such a composition for forming a silicon-containing resist underlayer film, it is possible to form a silicon-containing resist underlayer film that has an appropriate etching rate in the multilayer resist method and can improve LWR and CDU in an ultrafine pattern.

The thermally crosslinkable polysiloxane preferably contains any one or more of a repeating unit represented by the following general formula (Sx-1), a repeating unit represented by the following general formula (Sx-2), or a partial structure represented by the following general formula (Sx-3), 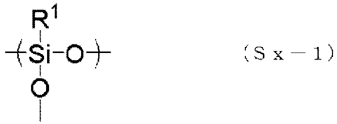 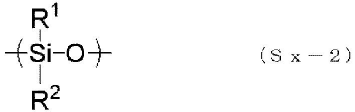 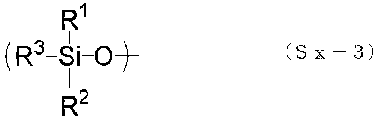 wherein R¹, R², and R³ are a monovalent organic group having 1 to 30 carbon atoms, which may be the same or different from each other.

When the thermally crosslinkable polysiloxane contains the specific structure described above, the effects of the present invention are more fully exhibited.

The inventive composition for forming a silicon-containing resist underlayer film preferably further comprises an acid generator.

By adding an acid generator as necessary, it is possible to finely adjust a pattern profile, exposure sensitivity, etc.

The acid generator is preferably a photoacid generator that generates an acid by action of a high-energy beam.

In this event, it is possible to appropriately adjust the pattern profile, exposure sensitivity, etc. of the resist upper layer film while minimizing deterioration of other performances. Additionally, in some cases, it may be effective in reducing residues derived from the resist upper layer film.

Further, the present invention provides a patterning process for forming a pattern in a body to be processed, comprising the steps of:
forming an organic film on a body to be processed by using a coating-type material for an organic film;
forming a silicon-containing resist underlayer film on the organic film by using the composition for forming a silicon-containing resist underlayer film according to the above;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask;
transferring the pattern to the organic film by etching while using the silicon-containing resist underlayer film having the transferred pattern as a mask; and
transferring the pattern to the body to be processed by etching while using the organic film having the transferred pattern as a mask.

Furthermore, the present invention provides a patterning process for forming a pattern in a body to be processed, comprising the steps of:
forming a hard mask on a body to be processed by a CVD method;
forming a silicon-containing resist underlayer film on the hard mask by using the composition for forming a silicon-containing resist underlayer film according to the above;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask;
transferring the pattern to the hard mask by dry etching while using the silicon-containing resist underlayer film having the transferred pattern as a mask; and
transferring the pattern to the body to be processed by dry etching while using the hard mask having the transferred pattern as a mask.

The patterning process described above suppresses pattern collapse of the resist upper layer film, is excellent in transferring the pattern to the silicon-containing resist underlayer film by dry etching, and it is easy to remove the silicon-containing resist underlayer film remaining after completion of the patterning and difficult to cause defects due to the residue. Accordingly, the patterning process described above is a practical patterning process especially for forming a fine pattern.

The circuit pattern is formed in the resist upper layer film preferably by photolithography using a light having a wavelength of 10 nm or more and 300 nm or less, direct drawing by an electron beam, nanoimprinting, or a combination thereof.

When a circuit pattern is formed on the resist upper layer film by the specific method above, the effects of the present invention are more fully exhibited.

The body to be processed may be a semiconductor device substrate or the semiconductor device substrate coated with any of a metal film, a metal carbide film, a metal oxide film, a metal nitride film, a metal oxycarbide film, and a metal oxynitride film.

When the body to be processed is the above specific one, the effects of the present invention are more fully exhibited.

Further, the metal to be used is preferably silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

When the body to be processed contains the above specific metal, the effects of the present invention are more fully exhibited.

### ADVANTAGEOUS EFFECTS OF INVENTION

As described above, by adding the inventive silicon-containing sulfonium salt compound as a curing catalyst to a composition for forming a silicon-containing resist underlayer film containing a thermally crosslinkable polysiloxane, it is capable of not only forming an ultrafine upper resist pattern having good LWR and CDU but also forming a pattern for semiconductor device on a substrate in a high yield because of having an excellent dry etching selectivity with respect to a resist upper layer film and an organic film or a hard mask. Further, because the formed silicon-containing resist underlayer film has high etching selectivity with respect to organic materials, the formed upper resist pattern can be transferred by dry etching process to a silicon-containing resist underlayer film and to an organic film or a hard mask sequentially. Furthermore, because the formed silicon-containing resist underlayer film has a sufficient etching rate, it is easy to remove the silicon-containing resist underlayer film remaining after completion of patterning and difficult to cause defects due to the residue, and it is particularly useful for forming fine patterns.

### DESCRIPTION OF EMBODIMENTS

As described above, it has been desired to develop a composition for forming a silicon-containing resist underlayer film capable of forming a silicon-containing resist underlayer film that has an appropriate etching rate in multilayer resist method and can improve LWR and CDU of an ultrafine pattern; a silicon-containing sulfonium salt compound contained in the composition; and a patterning process using the composition.

As a result of their diligent study to achieve the above objects, the inventors found that adding silicon-containing sulfonium salt compound having a specific structure to a composition for forming a silicon-containing resist underlayer film provided a multilayer resist method with a silicon-containing resist underlayer film having an etching rate appropriate for processing and improved LWR and CDU of an ultrafine pattern, and then have completed the present invention.

That is, the present invention is a silicon-containing sulfonium salt compound represented by the following general formula (A-1).

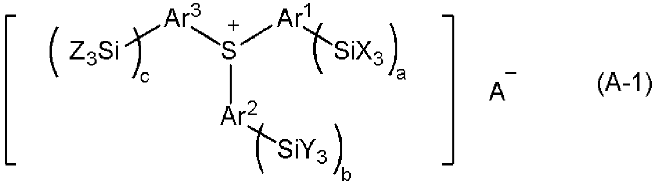

In the formula, Ar¹, Ar², and Ar³ are each independently an aromatic group having 6 to 20 carbon atoms and optionally containing a substituent, or a heteroaromatic group having 4 to 20 carbon atoms and optionally containing a substituent, and any two or more selected from the group consisting of Ar¹, Ar², and Ar³ may be bonded with each other to form a ring together with a sulfur atom in the formula; "a", "b", and "c" each independently are an integer of 0 to 3 and satisfy 1≤a+b+c≤9; X, Y, and Z represent a monovalent organic group having 1 to 14 carbon atoms, and may be the same or different from each other; and A⁻ represents an organic or inorganic anion that serves as a counter ion of a sulfonium cation.

Hereinafter, the present invention will be described in detail, but the present invention is not limited thereto.

<Composition for Forming Silicon-Containing Resist Underlayer Film>

The present composition for forming a silicon-containing resist underlayer film contains a silicon-containing sulfonium salt compound represented by the following general formula (A-1), and a thermally crosslinkable polysiloxane. In addition to these, any other components may be included.

Hereinafter, each component contained in the inventive composition for forming a silicon-containing resist underlayer film will be explained in detail.

### <Silicon-Containing Sulfonium Salt Compound>

The inventive silicon-containing sulfonium salt compound is a silicon-containing sulfonium salt compound represented by the following general formula (A-1), and is used as a curing catalyst.

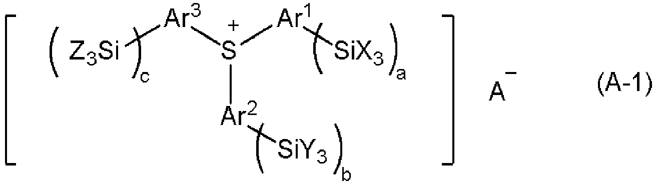

In the formula, Ar¹, Ar², and Ar³ are each independently an aromatic group having 6 to 20 carbon atoms and optionally containing a substituent, or a heteroaromatic group having 4 to 20 carbon atoms and optionally containing a substituent, and any two or more selected from the group consisting of Ar¹, Ar², and Ar³ may be bonded with each other to form a ring together with a sulfur atom in the formula; "a", "b", and "c" each independently are an integer of 0 to 3 and satisfy 1≤a+b+c≤9; X, Y, and Z represent a monovalent organic group having 1 to 14 carbon atoms, and may be the same or different from each other; and A⁻ represents an organic or inorganic anion that serves as a counter ion of a sulfonium cation.

The inventive silicon-containing sulfonium salt compound functions as a curing catalyst when added to a composition for forming a silicon-containing resist underlayer film and promotes heat-curing. During curing, the inventive compound has a high affinity with a silicon polymer and thus its diffusion into the upper resist layer is suppressed, contributing to improvement of LWR and CDU. Further, the formed silicon-containing resist underlayer film has an appropriate composition and structure, and is therefore considered to have a sufficient etching rate for processing.

Incidentally, in this specification, a film formed below the resist upper layer film is referred to as "underlayer film", and includes films referred to as "resist underlayer film" and "silicon-containing resist middle layer film."

In the above formula (A-1), Ar¹, Ar², and Ar³ are each independently an aromatic group having 6 to 20 carbon atoms and optionally containing a substituent, or a heteroaromatic group having 4 to 20 carbon atoms and optionally containing a substituent. Specific examples of the aromatic group having 6 to 20 carbon atoms include a phenyl group, a naphthyl group, an anthracenyl group, a phenanthrenyl group, and a pyrenyl group. Specific examples of the heteroaromatic group having 4 to 20 carbon atoms include a furanyl group, a thiophenyl group, a pyrrolyl group, a benzofuranyl group, a pyridinyl group, an indolyl group, an oxazolyl group, an imidazolyl group, and a benzimidazolyl group. Examples of the substituent optionally containing in the group include a linear, branched, or cyclic, saturated or unsaturated hydrocarbon group having 1 to 12 carbon atoms, an aromatic hydrocarbon group, a heteroaromatic group, an alkoxy group, a hydroxy group, an ester group, a carbonyl group, an amino group, a halogen group, a sulfide group, a carboxy group, a sulfo group, an amide group, an imide group, a cyano group, an aldehyde group, an imino group, an urea group, a carbamate group, a carbonate group, an nitro group, a sulfonyl group, and groups combining these groups. In order to more effectively exhibit the effects of the present invention, the preferable groups include a phenyl group, a naphthyl group, a furanyl group, a thiophenyl group, a pyrrolyl group, and a pyridinyl group, and more preferable groups include a phenyl group and a naphthyl group. In addition, any two or more selected from the group consisting of Ar¹, Ar², and Ar³ may be bonded with each other to form a ring together with a sulfur atom in the formula, but those that do not form a ring is more preferable from the viewpoint of solubility and stability.

In the above formula (A-1), X, Y, and Z represent a monovalent organic group having 1 to 14 carbon atoms, and may be the same or different from each other. The specific examples of the monovalent organic group having 1 to 14 carbon atoms include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, an alkenyl group, an oxoalkyl group, an aryl group, an aralkyl group, and an aryloxoalkyl group.

Examples of the alkenyl group include a vinyl group, an allyl group, a propenyl group, a butenyl group, a hexenyl group, and a cyclohexenyl group.

Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, and a 2-(4-methylcyclohexyl)-2-oxoethyl group.

Examples of the aryl group include: a phenyl group, a naphthyl group; alkoxyphenyl groups such as a p-methoxyphenyl group, an m-methoxyphenyl group, an o-methoxyphenyl group, an ethoxyphenyl group, a p-tert-butoxyphenyl group, and a m-tert-butoxyphenyl group; alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups such as a methylnaphthyl group and an ethylnaphthyl group; alkoxynaphthyl groups such as a methoxynaphthyl group and an ethoxynaphthyl group; dialkylnaphthyl groups such as a dimethylnaphthyl group and a diethylnaphthyl group; dialkoxynaphthyl groups such as a dimethoxynaphthyl group and a diethoxynaphthyl group.

Examples of the aralkyl group include a benzyl group, a phenylethyl group, and a phenethyl group.

Examples of the aryloxoalkyl group include 2-aryl-2-oxoethyl groups such as a 2-phenyl-2-oxoethyl group, a 2-(1-naphthyl)-2-oxoethyl group, and 2-(2-naphthyl)-2-oxoethyl group.

In order to more effectively exhibit the effects of the present invention, a methyl group, an ethyl group, and an isopropyl group are preferable, and a methyl group and an ethyl group are more preferable.

In the above formula (A-1), A⁻ represents an organic or inorganic anion that serves as a counter ion of a sulfonium cation. Specific examples of the organic anions include a formate, an acetate, a propionate, a butyrate, a hexanoate, a benzoate, a t-butylbenzoate, a trichloroacetate, a trifluoroacetate, a 2-hydroxy-2,2-bis(trifluoromethyl) acetate, a trimethyl acetate, a pentafluoropropionate, a methanesulfonate, a butanesulfonate, a benzenesulfonate, a toluenesulfonate, a trifluoromethanesulfonate, and a methyl sulfate ion. Specific examples of the inorganic anions include a chloride ion, a bromide ion, an iodide ion, a fluoride ion, a cyanide ion, a nitrate ion, a nitrite ion, and a hydroxide ion. Among these ions, a chloride ion, an iodide ion, a fluoride ion, a nitrate ion, a nitrite ion, and a hydroxide ion are preferable, and a chloride ion and a nitrate ion are more preferable.

In the present invention, one of the silicon-containing sulfonium salt compounds represented by the above general formula (A-1) may be used alone or a mixture of two or more thereof may be used. The blending amount of the silicon-containing sulfonium salt compound represented by the above general formula (A-1) is preferably 0.01 to 50 parts by mass, more preferably is 0.1 to 40 parts by mass relative to 100 parts by mass of a thermally crosslinkable polysiloxane (Sx), which will be described later.

Specific example of the silicon-containing sulfonium salt compound represented by the above general formula (A-1) include the following compounds, but are not limited thereto. In the following formulae, Me represents a methyl group, and the same applies hereinafter.

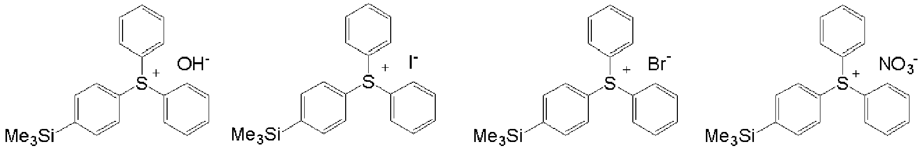

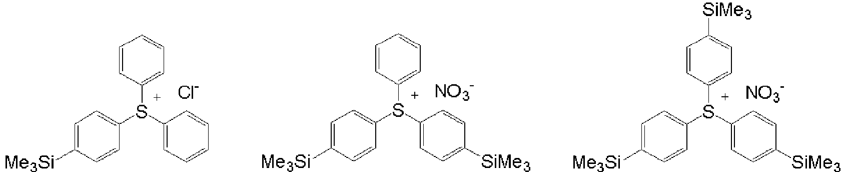

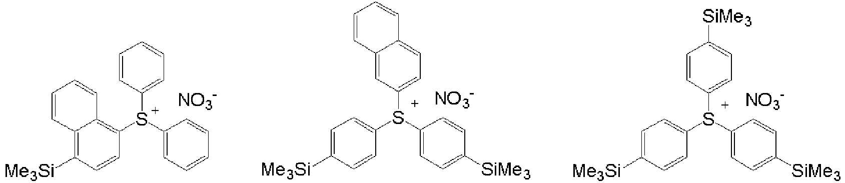

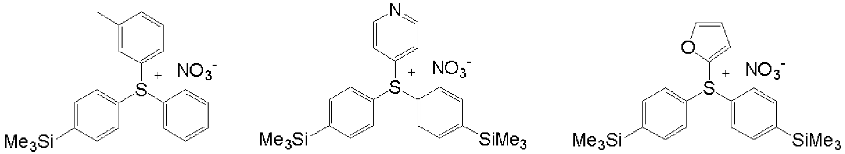

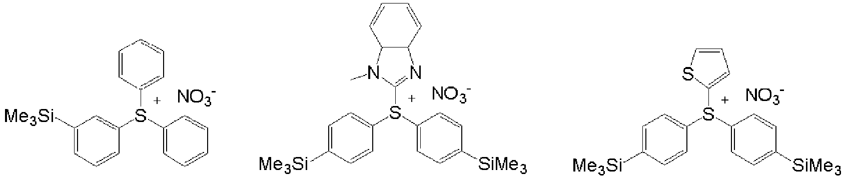

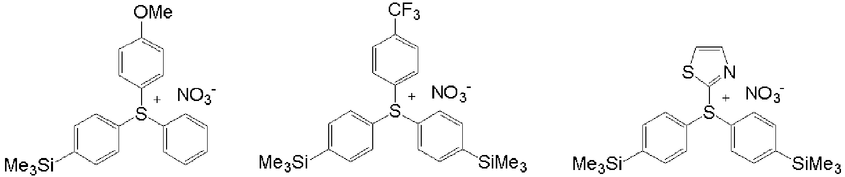

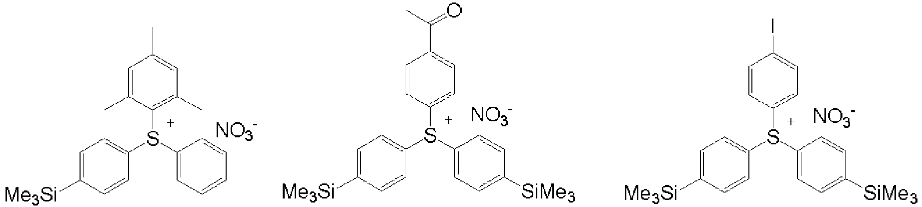

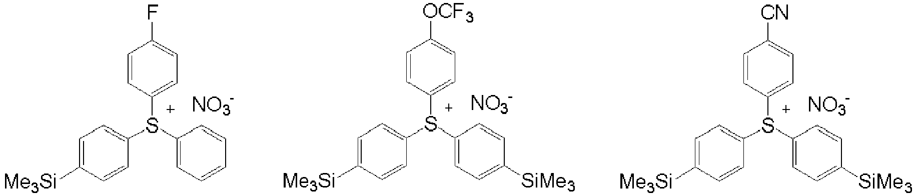

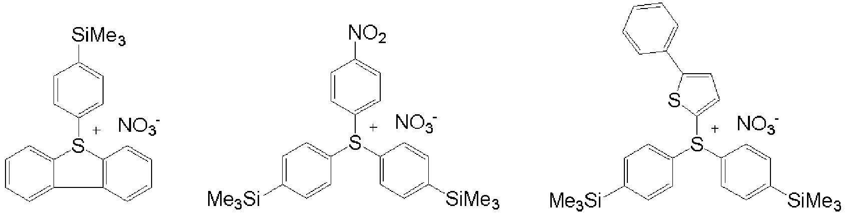

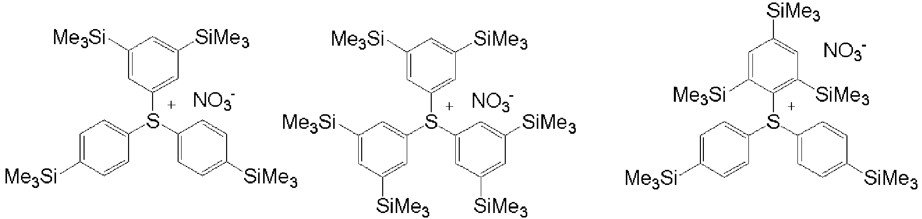

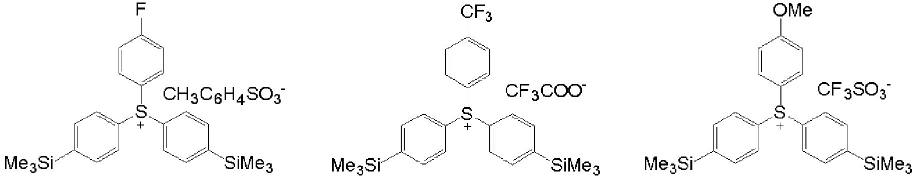

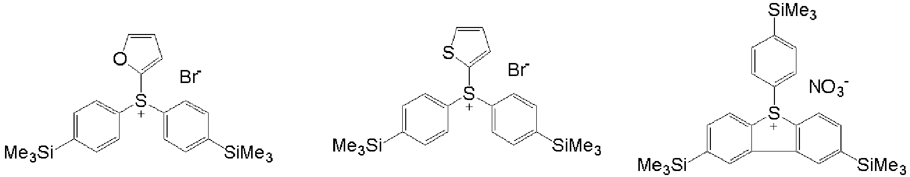

### [Thermally Crosslinkable Polysiloxane]

The inventive composition for forming a silicon-containing resist underlayer film contains a thermally crosslinkable polysiloxane in addition to one or two or more kinds of silicon-containing sulfonium salt compound represented by the above general formula (a-1).

The thermally crosslinkable polysiloxane (Sx) used in the present invention preferably contains any one or more selected from a repeating unit represented by the following general formula (Sx-1), a repeating unit represented by the following general formula (Sx-2), and a partial structure represented by the following general formula (Sx-3).

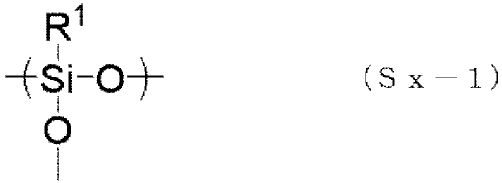

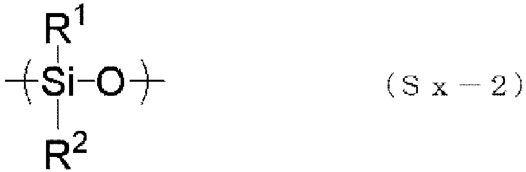

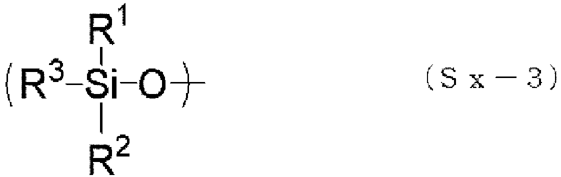

In the formulae, R¹, R², and R³ represent a monovalent organic group having 1 to 30 carbon atoms, which may be same as or different from each other.

The thermally crosslinkable polysiloxane (Sx) may be produced by hydrolytically condensing the following hydrolysable monomer (Sm), for example.

Specific examples of the hydrolysable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, isobutyltrimethoxysilane, isobutyltriethoxysilane, isobutyltripropoxysilane, isobutyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, allyltrimethoxysilane, allyltriethoxysilane, allyltripropoxysilane, allyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, and dimethylphenethylethoxysilane.

Preferable examples of the above compounds include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, and dimethylphenethylmethoxysilane.

Other examples of the organic group represented by the above R¹, R², and R³ include organic groups having one or more carbon-oxygen single bonds or carbon-oxygen double bonds. Specifically, they are organic groups having one or more groups selected from the group consisting of an ether bond, an ester bond, an alkoxy group, a hydroxy group, etc. Examples thereof include groups represented by the following general formula (Sm-R) .

(P-Q₁-(S₁)ᵥ₁-Q₂-)ᵤ-(T)ᵥ₂-Q₃-(S₂)ᵥ₃-Q₄- (Sm-R)

In the general formula (Sm-R), P represents a hydrogen atom, a cyclic ether group, a hydroxy group, an alkoxy group having 1 to 4 carbon atoms, an alkylcarbonyloxy group having 2 to 6 carbon atoms, or an alkylcarbonyl group having 2 to 6 carbon atoms; Q₁, Q₂, Q₃, and Q₄ each independently represent -C_{q}H_{(2q-p)}Pₚ- (in the formula, P is as defined above, "p" represents an integer of 0 to 3, and "q" represents an integer of 0 to 10, provided that the formula represents a single bond when q=0.); "u" represents an integer of 0 to 3; S₁ and S₂ each independently represent -O-, -CO-, -OCO-, -COO-, or -OCOO-; "v1", "v2", and "v3" each independently represent 0 or 1; and T represents a divalent atom except for carbon or a divalent group including an aliphatic ring, an aromatic ring, or a heteroaromatic ring.

As T, examples of the aliphatic ring, the aromatic ring, or the heteroaromatic ring optionally having a heteroatom such as an oxygen atom are described below. In T, attachment points to Q₂ and Q₃ are not particularly limited, and may be appropriately selected with considering reactivity due to a steric factor, availability of commercial reagents used for the reaction, etc.

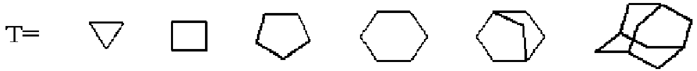

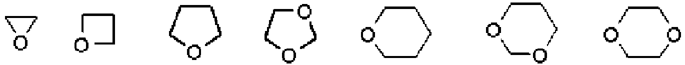

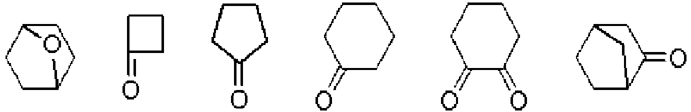

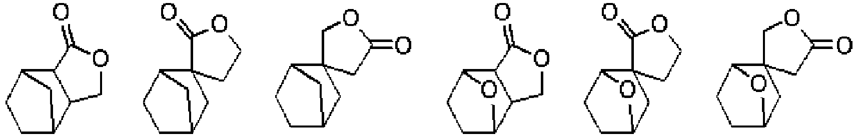

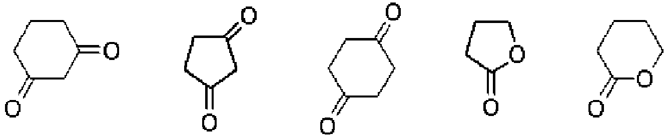

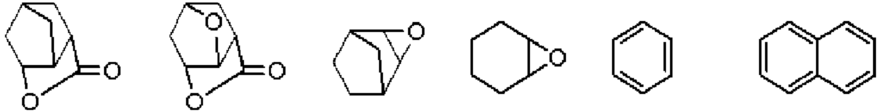

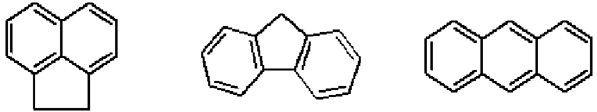

Preferable examples of the organic group having one or more carbon-oxygen single bonds or carbon-oxygen double bonds in the general formula (Sm-R) include the following groups. In the following formulae, (Si) is described to indicate a bonding portion with an Si atom.

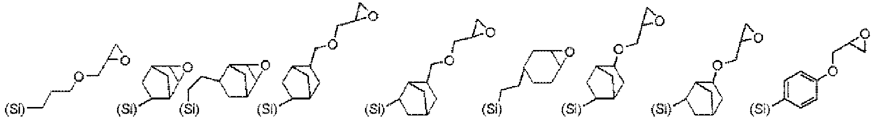

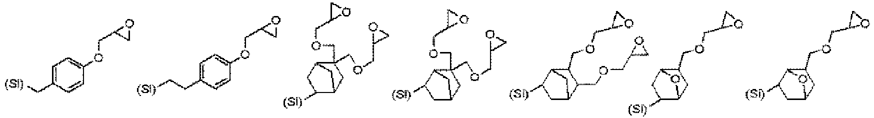

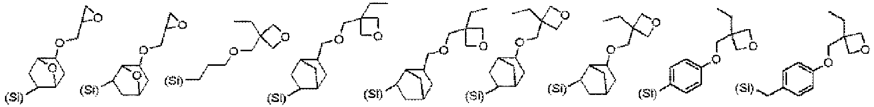

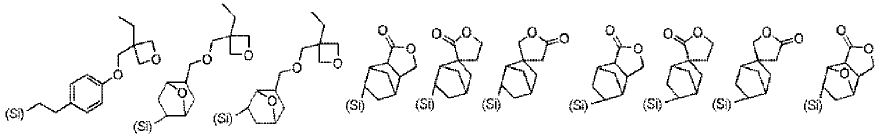

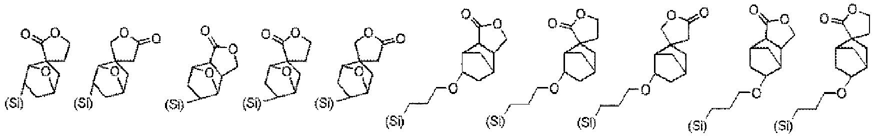

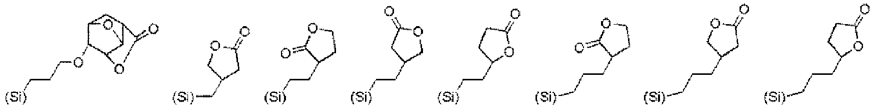

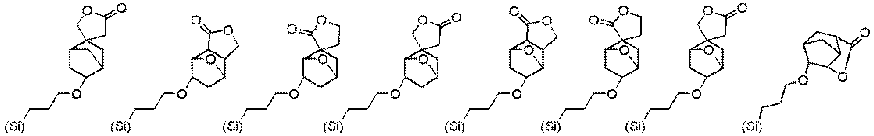

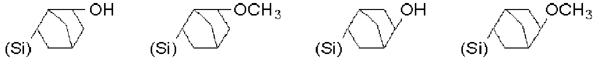

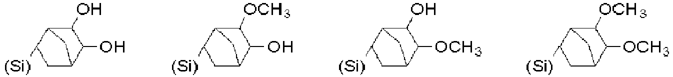

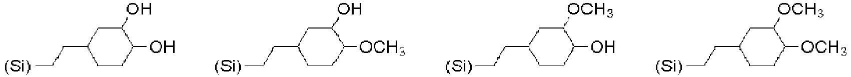

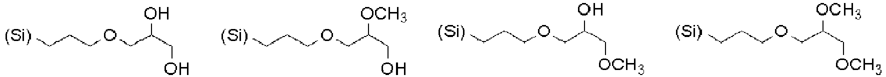

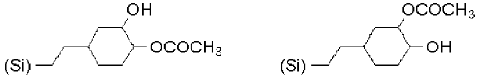

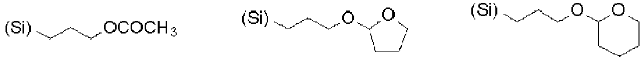

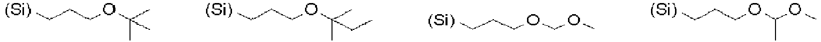

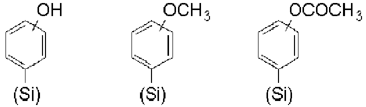

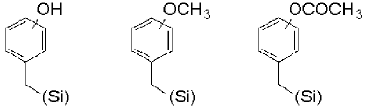

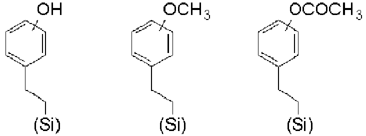

As an example of the organic groups of R¹, R², and R³, an organic group having a silicon-silicon bond may also be used. Specific examples thereof include the followings.

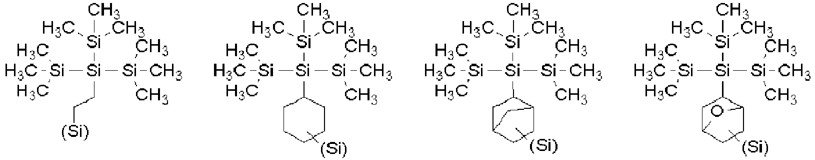

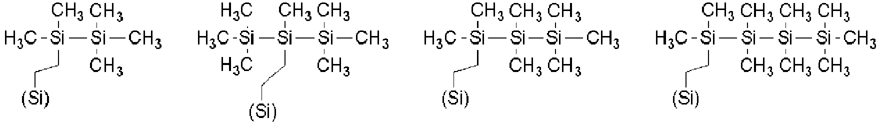

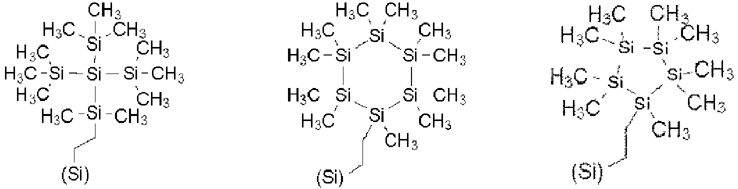

As an example of the organic groups of R¹, R², and R³, an organic group having a protective group to be decomposed by an acid may also be used. Specific examples thereof include organic groups disclosed in paragraphs [0043] to [0048] of JP2013-167669A, and organic groups obtained from silicon compounds disclosed in a paragraph [0056] of JP2013-224279A.

As an example of the organic groups of R¹, R², and R³, an organic group having a fluorine atom may be further used. Specific examples thereof include organic groups obtained from silicon compounds disclosed in paragraphs [0059] to [0065] of JP2012-053253A.

In the above hydrolysable monomer (Sm), one, two, or three chlorine, bromine, iodine, acetoxy groups, methoxy groups, ethoxy groups, propoxy groups, butoxy groups, or the like are bonded, as the hydrolysable group, to the silicon indicated as (Si) in the above partial structures.

### [Synthesis Method of Thermally Crosslinkable Polysiloxane (Sx)]

### (Synthesis Method 1: Acid Catalyst)

The thermally crosslinkable polysiloxane (Sx) used in the present invention can be produced by hydrolytically condensing a mixture of one or two or more of the hydrolysable monomer (Sm) in the presence of an acid catalyst.

Examples of the acid catalyst used in this case include: organic acids such as formic acid, acetic acid, oxalic acid, maleic acid, methanesulfonic acid, benzenesulfonic acid, and toluenesulfonic acid; hydrofluoric acid; hydrochloric acid; hydrobromic acid; sulfuric acid; nitric acid; perchloric acid; and phosphoric acid. A use amount of the catalyst is preferably 1×10⁻⁶ to 10 mol, more preferably 1×10⁻⁵ to 5 mol, and further preferably 1×10⁻⁴ to 1 mol relative to 1 mol of the monomer.

An amount of water added for obtaining the thermally crosslinkable polysiloxane (Sx) from these monomers via the hydrolytic condensation is preferably 0.01 to 100 mol, more preferably 0.05 to 50 mol, and further preferably 0.1 to 30 mol per mole of the hydrolysable substituent bonded to the monomer. When the amount is 100 mol or less, an apparatus used for the reaction may be small, which is economical. When the amount is 0.01 mol or more, the reaction proceeds sufficiently.

As the procedure, the monomer is added into an aqueous solution of the catalyst to initiate the hydrolytic condensation reaction. In this case, an organic solvent may be added into the aqueous solution of the catalyst, the monomer may be diluted in advance with an organic solvent, or both of them may be performed. The reaction temperature is preferably 0 to 100°C, and more preferably 5 to 80°C. A preferable method is retaining the temperature to 5 to 80°C during dropwise addition of the monomer, and then aging at 20 to 80°C.

Preferable organic solvents that can be added into the aqueous solution of the catalyst or that can dilute the monomer include methanol, ethanol, 1-propanol, 2-propanol, 1-butanol, 2-butanol, 2-methyl-1-propanol, ethylene glycol, propylene glycol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, and a mixture thereof.

Preferable solvents among these are water-soluble solvents. Examples thereof include: alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone; acetonitrile; and tetrahydrofuran. Particularly preferable solvents among these have a boiling point of 100°C or lower.

An amount of the used organic solvent is preferably 0 to 1,000 ml, and particularly preferably 0 to 500 ml relative to 1 mol of the monomer. When the amount of the used organic solvent is smaller, a reaction vessel may be smaller, which is economical.

Thereafter, a neutralization reaction of the catalyst is performed as necessary to obtain an aqueous solution of the reaction mixture. In this case, an amount of an alkaline substance that can be used for the neutralization is preferably 0.1 to 2 equivalents relative to the used acid as the catalyst. This alkaline substance may be any substance as long as it exhibits alkalinity in water.

Subsequently, a byproduct such as an alcohol generated by the hydrolytic condensation reaction is preferably removed from the reaction mixture under a reduced pressure, etc. In this time, a temperature at which the reaction mixture is heated is preferably 0 to 100°C, more preferably 10 to 90°C, and further preferably 15 to 80°C, depending on types of the added organic solvent and the alcohol generated in the reaction. A pressure reducing degree in this case is preferably the atmospheric pressure or lower, more preferably 80 kPa or lower as an absolute pressure, and further preferably 50 kPa or lower as an absolute pressure, which varies depending on types of the organic solvent and alcohol to be removed, a ventilation apparatus, a condensation apparatus, and the heating temperature. Although an amount of the removed alcohol in this case is difficult to be accurately determined, approximately 80 mass% or more of the generated alcohol, etc. is desirably removed.

Then, the acid catalyst used for the hydrolytic condensation may be removed from the aqueous solution of the reaction mixture. As a method for removing the acid catalyst, water and the solution of the thermally crosslinkable polysiloxane are mixed, and the thermally crosslinkable polysiloxane is extracted with an organic solvent. The organic solvent used in this case is preferably an organic solvent that can dissolve the thermally crosslinkable polysiloxane and that forms separated two layers when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, and a mixture thereof.

Furthermore, a mixture of a water-soluble organic solvent and a water-hardly-soluble organic solvent can also be used. Examples of preferable mixtures include a methanol-ethyl acetate mixture, an ethanol-ethyl acetate mixture, a 1-propanol-ethyl acetate mixture, a 2-propanol-ethyl acetate mixture, a butanediol monomethyl ether-ethyl acetate mixture, a propylene glycol monomethyl ether-ethyl acetate mixture, an ethylene glycol monomethyl ether-ethyl acetate mixture, a butanediol monoethyl ether-ethyl acetate mixture, a propylene glycol monoethyl ether-ethyl acetate mixture, an ethylene glycol monoethyl ether-ethyl acetate mixture, a butanediol monopropyl ether-ethyl acetate mixture, a propylene glycol monopropyl ether-ethyl acetate mixture, an ethylene glycol monopropyl ether-ethyl acetate mixture, a methanol-methyl isobutyl ketone mixture, an ethanol-methyl isobutyl ketone mixture, a 1-propanol-methyl isobutyl ketone mixture, a 2-propanol-methyl isobutyl ketone mixture, a propylene glycol monomethyl ether-methyl isobutyl ketone mixture, an ethylene glycol monomethyl ether-methyl isobutyl ketone mixture, a propylene glycol monoethyl ether-methyl isobutyl ketone mixture, an ethylene glycol monoethyl ether-methyl isobutyl ketone mixture, a propylene glycol monopropyl ether-methyl isobutyl ketone mixture, an ethylene glycol monopropyl ether-methyl isobutyl ketone mixture, a methanol-cyclopentyl methyl ether mixture, an ethanol-cyclopentyl methyl ether mixture, a 1-propanol-cyclopentyl methyl ether mixture, a 2-propanol-cyclopentyl methyl ether mixture, a propylene glycol monomethyl ether-cyclopentyl methyl ether mixture, an ethylene glycol monomethyl ether-cyclopentyl methyl ether mixture, a propylene glycol monoethyl ether-cyclopentyl methyl ether mixture, an ethylene glycol monoethyl ether-cyclopentyl methyl ether mixture, a propylene glycol monopropyl ether-cyclopentyl methyl ether mixture, an ethylene glycol monopropyl ether-cyclopentyl methyl ether mixture, a methanol-propylene glycol methyl ether acetate mixture, an ethanol-propylene glycol methyl ether acetate mixture, a 1-propanol-propylene glycol methyl ether acetate mixture, a 2-propanol-propylene glycol methyl ether acetate mixture, a propylene glycol monomethyl ether-propylene glycol methyl ether acetate mixture, an ethylene glycol monomethyl ether-propylene glycol methyl ether acetate mixture, a propylene glycol monoethyl ether-propylene glycol methyl ether acetate mixture, an ethylene glycol monoethyl ether-propylene glycol methyl ether acetate mixture, a propylene glycol monopropyl ether-propylene glycol methyl ether acetate mixture, and an ethylene glycol monopropyl ether-propylene glycol methyl ether acetate mixture. However, the combination is not limited thereto.

A mixing ratio between the water-soluble organic solvent and the water-hardly-soluble organic solvent may be appropriately selected, and is preferably 0.1 to 1,000 parts by mass, more preferably 1 to 500 parts by mass, and further preferably 2 to 100 parts by mass of the water-soluble organic solvent, relative to 100 parts by mass of the water-hardly-soluble organic solvent.

Subsequently, the reaction mixture may be washed with neutral water. As this water, so-called deionized water or ultrapure water may be used. An amount of this water is preferably 0.01 to 100 L, more preferably 0.05 to 50 L, and further preferably 0.1 to 5 L relative to 1 L of the solution of the thermally crosslinkable polysiloxane. In this washing method, the both may be added into one vessel, and the mixture is stirred and left to stand to separate the aqueous layer. A washing time may be one or more, and preferably one to approximately five because even ten times or more of washing does not yield an effect commensurate that number of times.

Examples of another method for removing the acid catalyst include: a method with an ion-exchange resin; and a method of neutralization with an epoxy compound such as ethylene oxide and propylene oxide and then removing the neutralized product. These methods may be appropriately selected according to the acid catalyst used for the reaction.

The washing procedure with water in this time may allow a part of the thermally crosslinkable polysiloxane to escape into the aqueous layer and yield an effect substantially same as a fractioning procedure. Thus, the washing time with water and the amount of washing water may be appropriately selected with considering the effect of removing the catalyst and the effect of fractioning.

In any of the solution of the thermally crosslinkable polysiloxane with a remained acid catalyst and the solution of the thermally crosslinkable polysiloxane with removed acid catalyst, a final solvent is added and solvent exchange is performed under a reduced pressure to obtain a desired solution of the thermally crosslinkable polysiloxane. A temperature of the solvent exchange in this case is preferably 0 to 100°C, more preferably 10 to 90°C, and further preferably 15 to 80°C, depending on types of the reaction solvent and extraction solvent to be removed. A pressure reducing degree in this case is preferably the atmospheric pressure or lower, more preferably 80 kPa or lower as an absolute pressure, and further preferably 50 kPa or lower as an absolute pressure, which differs depending on a type of the extraction solvent to be removed, a ventilation apparatus, a condensation apparatus, and the heating temperature.

In this case, the thermally crosslinkable polysiloxane may be destabilized by changing the solvent. This destabilization is caused by compatibility between the final solvent and the thermally crosslinkable polysiloxane. To prevent this destabilization, a monovalent or divalent or more alcohol having a cyclic ether as a substituent described in paragraphs [0181] to [0182] in JP2009-126940A may be added as a stabilizer. An amount of the stabilizer to be added is preferably 0 to 25 parts by mass, more preferably 0 to 15 parts by mass, and further preferably 0 to 5 parts by mass relative to 100 parts by mass of the thermally crosslinkable polysiloxane in the solution before the solvent exchange. When the stabilizer is added, the amount is preferably 0.5 parts by mass or more. As necessary, the monovalent or divalent or more alcohol having a cyclic ether as a substituent may be added into the solution before the solvent exchange, and then the solvent exchange procedure may be performed.

The thermally crosslinkable polysiloxane is preferably maintained as a solution state at an appropriate concentration. The concentration in this case is preferably 0.1 to 20 mass%. At such a concentration, no further condensation reaction occurs, so that the state does not change to a state where it cannot be redissolved in the organic solvent. Moreover, the amount of solvent is reduced, which is economical and preferable.

The final solvent added into the solution of the thermally crosslinkable polysiloxane is preferably alcoholic solvents. Particularly preferable alcoholic solvents are monoalkyl ether derivatives of ethylene glycol, diethylene glycol, triethylene glycol, propylene glycol, dipropylene glycol, butanediol, or the like. Specifically, preferable solvents include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, and diacetone alcohol.

When these solvents are the main component, non-alcoholic solvents can be added as an auxiliary solvent. Examples of the auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, and cyclopentyl methyl ether.

As another reaction procedure using the acid catalyst, water or a water-containing organic solvent is added into the monomer or an organic solution of the monomer to initiate the hydrolysis reaction. In this case, the catalyst may be added into the monomer or the organic solution of the monomer, or may be added in advance into the water or the water-containing organic solvent. The reaction temperature is preferably 0 to 100°C, and more preferably 10 to 80°C. A preferable method is heating during dropwise addition of the water at 10 to 50°C, and then raising the temperature to 20 to 80°C to age the reaction mixture.

When being used, the organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, propylene glycol monopropyl ether, and a mixture thereof.

An amount of the used organic solvent is preferably 0 to 1,000 ml, and particularly preferably 0 to 500 ml relative to 1 mol of the monomer. The smaller the amount of the used organic solvent is, the smaller a reaction vessel is, which is economical. The aqueous solution of the obtained reaction mixture can be aftertreated in the same manner as the above method to obtain the thermally crosslinkable polysiloxane.

### (Synthesis Method 2: Alkali Catalyst)

The thermally crosslinkable polysiloxane (Sx) may also be produced by hydrolytically condensing a mixture of one or two or more types of the hydrolysable monomer (Sm) in the presence of an alkali catalyst. Examples of the alkali catalyst used in this case include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethylmonoethanolamine, monomethyldiethanolamine, triethanolamine, diazabicyclooctane, diazabicyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, and calcium hydroxide. An amount of the used catalyst is preferably 1×10⁻⁶ to 10 mol, more preferably 10⁻⁵ to 5 mol, and further preferably 1×10⁻⁴ to 1 mol, relative to 1 mol of the monomer.

An amount of water added for obtaining the thermally crosslinkable polysiloxane from the monomer via the hydrolytic condensation is preferably 0.1 to 50 mol relative to 1 mol of the hydrolysable substituent bonded to the monomer. When the amount is 50 mol or less, an apparatus used for the reaction may be small, which is economical. When the amount is 0.01 mol or more, the reaction proceeds sufficiently.

As the procedure, the monomer is added into an aqueous solution of the catalyst to initiate the hydrolytic condensation reaction. In this case, an organic solvent may be added into the aqueous solution of the catalyst, the monomer may be diluted in advance with an organic solvent, or both of them may be performed. The reaction temperature is preferably 0 to 100°C, and more preferably 5 to 80°C. A preferable method is retaining the temperature to 5 to 80°C during dropwise addition of the monomer, and then aging at 20 to 80°C.

Preferably used organic solvents that can be added into the aqueous solution of the alkali catalyst or that can dilute the monomer are the organic solvents same as those exemplified as the organic solvent that can be added into the aqueous solution of the acid catalyst. An amount of the used organic solvent is preferably 0 to 1,000 ml relative to 1 mol of the monomer for the economical reaction.

Thereafter, a neutralization reaction of the catalyst is performed as necessary to obtain an aqueous solution of the reaction mixture. In this case, an amount of an acidic substance that can be used for the neutralization is preferably 0.1 to 2 equivalents relative to the alkaline substance used as the catalyst. This acidic substance may be any substance as long as it exhibits acidity in water.

Subsequently, a byproduct such as an alcohol generated by the hydrolytic condensation reaction is preferably removed from the aqueous solution of the reaction mixture under a reduced pressure, etc. In this time, a temperature at which the aqueous solution of the reaction mixture is heated is preferably 0 to 100°C, more preferably 10 to 90°C, and further preferably 15 to 80°C, depending on types of the added organic solvent and alcohol generated in the reaction. A pressure reducing degree in this case is preferably the atmospheric pressure or lower, more preferably 80 kPa or lower as an absolute pressure, and further preferably 50 kPa or lower as an absolute pressure, which differs depending on types of the organic solvent and alcohol to be removed, a ventilation apparatus, a condensation apparatus, and the heating temperature. Although an amount of the removed alcohol in this case is difficult to be accurately determined, approximately 80 mass% or more of the generated alcohol is desirably removed.

Then, to remove the catalyst used for the hydrolytic condensation, the thermally crosslinkable polysiloxane is extracted with an organic solvent. The organic solvent used in this case is preferably an organic solvent that can dissolve the thermally crosslinkable polysiloxane and that forms separated two layers when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, tert-butyl propionate, propylene glycol mono-t-butyl ether acetate, γ-butyrolactone, methyl isobutyl ketone, cyclopentyl methyl ether, and a mixture thereof.

Further, a mixture of a water-soluble organic solvent and a water-hardly-soluble organic solvent can also be used.

Specific examples of the organic solvent used for removing the alkali catalyst include: the above specifically exemplified organic solvents used for removing the acid catalyst; and organic solvents same as the mixture of the water-soluble organic solvent and the water-hardly soluble organic solvent.

A mixing ratio between the water-soluble organic solvent and the water-hardly-soluble organic solvent is appropriately selected, and is preferably 0.1 to 1,000 parts by mass, more preferably 1 to 500 parts by mass, and further preferably 2 to 100 parts by mass of the water-soluble organic solvent, relative to 100 parts by mass of the water-hardly-soluble organic solvent.

Subsequently, the reaction mixture is washed with neutral water. As this water, so-called deionized water or ultrapure water is typically used. An amount of this water is preferably 0.01 to 100 L, more preferably 0.05 to 50 L, and further preferably 0.1 to 5 L, relative to 1 L of the solution of the thermally crosslinkable polysiloxane. In this washing method, the both are added into one vessel, and the mixture is stirred and left to stand to separate the aqueous layer. A washing time is one or more, and preferably one to approximately five because even ten times or more of washing does not yield an effect commensurate with that number of times.

Into the washed solution of the thermally crosslinkable polysiloxane, a final solvent is added and solvent exchange is performed under a reduced pressure to obtain a solution of the desired thermally crosslinkable polysiloxane. A temperature of the solvent exchange in this case is preferably 0 to 100°C, more preferably 10 to 90°C, and further preferably 15 to 80°C, depending on a type of the extraction solvent to be removed. A pressure reducing degree in this case is preferably the atmospheric pressure or lower, more preferably 80 kPa or lower as an absolute pressure, and further preferably 50 kPa or lower as an absolute pressure, which differs depending on a type of the extraction solvent to be removed, a ventilation apparatus, a condensation apparatus, and the heating temperature.

The final solvent added into the solution of the thermally crosslinkable polysiloxane is preferably alcoholic solvents. Particularly preferable alcoholic solvents are monoalkyl ether derivative such as ethylene glycol, diethylene glycol, triethylene glycol, propylene glycol, and dipropylene glycol. Specifically, preferable solvents are propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, etc.

As another reaction procedure using the alkali catalyst, water or a water-containing organic solvent is added into the monomer or an organic solution of the monomer to initiate the hydrolysis reaction. In this case, the catalyst may be added into the monomer or the organic solution of the monomer, or may be added in advance into the water or the water-containing organic solvent. The reaction temperature is preferably 0 to 100°C, and more preferably 10 to 80°C. A preferable method is heating at 10 to 50°C during dropwise addition of the water, and then raising the temperature to 20 to 80°C to age the reaction mixture.

The usable organic solvent as the organic solution of the monomer or the water-containing organic solvent is preferably water-soluble. Examples thereof include methanol, ethanol, 1-propanol, 2-propanol, 1-butanol, 2-butanol, 2-methyl-1-propanol, acetone, tetrahydrofuran, acetonitrile, polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and a mixture thereof.

A molecular weight of the thermally crosslinkable polysiloxane obtained by the above synthetic method 1 or 2 can be regulated by not only selecting the monomer but also controlling the reaction condition of the polymerization. When the weight-average molecular weight is 100,000 or less, no foreign matter nor coating unevenness occurs. Therefore, a preferably used thermally crosslinkable polysiloxane has a weight-average molecular weight of 100,000 or less, more preferably 200 to 50,000, and further preferably 300 to 30,000. Incidentally, data on the above weight-average molecular weight indicate the molecular weight in terms of polystyrene by gel permeation chromatography (GPC) using tetrahydrofuran as an eluent solvent, using RI as a detector, and using polystyrene as a standard substance.

The thermally crosslinkable polysiloxane used in the present invention has different physical properties depending on types of the acid or alkali catalyst used in the hydrolytic condensation and the reaction condition. Thus, the catalyst and the reaction condition can be appropriately selected according to target performance of the resist underlayer film.

Further, a polysiloxane derivative produced from a mixture of one or two or more of the hydrolysable monomer (Sm) and a hydrolysable metal compound represented by the following general formula (Mm) under the condition using the acid or alkali catalyst may be used as a component in the composition for forming a resist underlayer film.

U(OR⁷)ₘ₇(OR⁸)ₘ₈ (Mm)

In the formula (Mm), R⁷ and R⁸ each independently represent an organic group having 1 to 30 carbon atoms; m7+m8 is same as a valence number determined by a type of U, "m7" and "m8" represent an integer of 0 or more; and U represents a III-group, IV-group, or V-group element in the periodic table except for carbon and silicon.

Examples of the hydrolysable metal compound represented by the above formula (Mm) used in this event include the following. When U is boron, examples of the hydrolysable metal compound represented by the general formula (Mm) include, boron methoxide, boron ethoxide, boron propoxide, boron butoxide, boron amyloxide, boron hexyloxide, boron cyclopentoxide, boron cyclohexyloxide, boron allyloxide, boron phenoxide, boron methoxyethoxide, boric acid, and boron oxide.

When U is aluminum, examples of the hydrolysable metal compound represented by the general formula (Mm) include, aluminum methoxide, aluminum ethoxide, aluminum propoxide, aluminum butoxide, aluminum amyloxide, aluminum hexyloxide, aluminum cyclopentoxide, aluminum cyclohexyloxide, aluminum allyloxide, aluminum phenoxide, aluminum methoxyethoxide, aluminum ethoxyethoxide, aluminum dipropoxy(ethyl acetoacetate), aluminum dibutoxy(ethyl acetoacetate), aluminum propoxy bis(ethyl acetoacetate), aluminum butoxy bis(ethyl acetoacetate), aluminum 2,4-pentanedionate, and aluminum 2,2,6,6-tetramethyl-3,5-heptanedionate.

When U is gallium, examples of the hydrolysable metal compound represented by the general formula (Mm) include, gallium methoxide, gallium ethoxide, gallium propoxide, gallium butoxide, gallium amyloxide, gallium hexyloxide, gallium cyclopentoxide, gallium cyclohexyloxide, gallium allyloxide, gallium phenoxide, gallium methoxyethoxide, gallium ethoxyethoxide, gallium dipropoxy(ethyl acetoacetate), gallium dibutoxy(ethyl acetoacetate), gallium propoxy bis(ethyl acetoacetate), gallium butoxy bis(ethyl acetoacetate), gallium 2,4-pentanedionate, and gallium 2,2,6,6-tetramethyl-3,5-heptanedionate.

When U is yttrium, examples of the hydrolysable metal compound represented by the general formula (Mm) include, yttrium methoxide, yttrium ethoxide, yttrium propoxide, yttrium butoxide, yttrium amyloxide, yttrium hexyloxide, yttrium cyclopentoxide, yttrium cyclohexyloxide, yttrium allyloxide, yttrium phenoxide, yttrium methoxyethoxide, yttrium ethoxyethoxide, yttrium dipropoxy(ethyl acetoacetate), yttrium dibutoxy(ethyl acetoacetate), yttrium propoxy bis(ethyl acetoacetate), yttrium butoxy bis(ethyl acetoacetate), yttrium 2,4-pentanedionate, and yttrium 2,2,6,6-tetramethyl-3,5-heptanedionate.

When U is germanium, examples of the hydrolysable metal compound represented by the general formula (Mm) include, germanium methoxide, germanium ethoxide, germanium propoxide, germanium butoxide, germanium amyloxide, germanium hexyloxide, germanium cyclopentoxide, germanium cyclohexyloxide, germanium allyloxide, germanium phenoxide, germanium methoxyethoxide, and germanium ethoxyethoxide.

When U is titanium, examples of the hydrolysable metal compound represented by the general formula (Mm) include, titanium methoxide, titanium ethoxide, titanium propoxide, titanium butoxide, titanium amyloxide, titanium hexyloxide, titanium cyclopentoxide, titanium cyclohexyloxide, titanium allyloxide, titanium phenoxide, titanium methoxyethoxide, titanium ethoxyethoxide, titanium dipropoxy bis(ethyl acetoacetate), titanium dibutoxy bis(ethyl acetoacetate), titanium dipropoxy bis(2,4-pentanedionate), and titanium dibutoxy bis(2,4-pentanedionate).

When U is hafnium, examples of the hydrolysable metal compound represented by the general formula (Mm) include, hafnium methoxide, hafnium ethoxide, hafnium propoxide, hafnium butoxide, hafnium amyloxide, hafnium hexyloxide, hafnium cyclopentoxide, hafnium cyclohexyloxide, hafnium allyloxide, hafnium phenoxide, hafnium methoxyethoxide, hafnium ethoxyethoxide, hafnium dipropoxy bis(ethyl acetoacetate), hafnium dibutoxy bis(ethyl acetoacetate), hafnium dipropoxy bis(2,4-pentanedionate), and hafnium dibutoxy bis(2,4-pentanedionate).

When U is tin, examples of the hydrolysable metal compound represented by the general formula (Mm) include, methoxy tin, ethoxy tin, propoxy tin, butoxy tin, phenoxy tin, methoxyethoxy tin, ethoxyethoxy tin, tin 2,4-pentanedionate, and tin 2,2,6,6-tetramethyl-3,5-heptanedionate.

When U is arsenic, examples of the hydrolysable metal compound represented by the general formula (Mm) include, methoxy arsenic, ethoxy arsenic, propoxy arsenic, butoxy arsenic, and phenoxy arsenic.

When U is antimony, examples of the hydrolysable metal compound represented by the general formula (Mm) include, methoxy antimony, ethoxy antimony, propoxy antimony, butoxy antimony, phenoxy antimony, antimony acetate, and antimony propionate.

When U is niobium, examples of the hydrolysable metal compound represented by the general formula (Mm) include, methoxy niobium, ethoxy niobium, propoxy niobium, butoxy niobium, and phenoxy niobium.

When U is tantalum, examples of the hydrolysable metal compound represented by the general formula (Mm) include, methoxy tantalum, ethoxy tantalum, propoxy tantalum, butoxy tantalum, and phenoxy tantalum.

When U is bismuth, examples of the hydrolysable metal compound represented by the general formula (Mm) include, methoxy bismuth, ethoxy bismuth, propoxy bismuth, butoxy bismuth, and phenoxy bismuth.

When U is phosphorus, examples of the hydrolysable metal compound represented by the general formula (Mm) include, trimethyl phosphate, triethyl phosphate, tripropyl phosphate, trimethyl phosphite, triethyl phosphite, tripropyl phosphite, and diphosphorous pentaoxide.

When U is vanadium, examples of the hydrolysable metal compound represented by the general formula (Mm) include, vanadium oxide bis(2,4-pentanedionate), vanadium 2,4-pentanedionate, vanadium tributoxide oxide, and vanadium tripropoxide oxide.

When U is zirconium, examples of the hydrolysable metal compound represented by the general formula (Mm) include, methoxy zirconium, ethoxy zirconium, propoxy zirconium, butoxy zirconium, phenoxy zirconium, zirconium dibutoxide bis(2,4-pentanedionate), and zirconium dipropoxide bis(2,2,6,6-tetramethyl-3,5-heptanedionate).

In the present composition for forming a silicon-containing resist underlayer film, the blending amount of a thermally crosslinkable polysiloxane (Sx) is, for example, preferably 0.1 to 10 mass% relative to the solvent.

### [Acid Generator]

The present composition for forming a silicon-containing resist underlayer film preferably includes an acid generator further. One or two or more acid generators may be blended. Although any substance may be used as the acid generator as far as it serves as an acid precursor such as a thermal acid generator, a photoacid generator, and an acid proliferation agent, in the present invention, the acid generator is preferably a photoacid generator to generate an acid by an action of high-energy beam and more preferably a photoacid generator in which the blended acid generator is a sulfonium salt to generate an acid by an action of high-energy beam. More specifically, materials disclosed in paragraphs [0160] to [0179] in JP2009-126940A may be exemplified, but not limited thereto. The blending amount of the acid generator is preferably 0 to 10 parts by mass, more preferably 0.1 to 5 parts by mass, relative to 100 parts by mass of the thermally crosslinkable polysiloxane (Sx).

### [Other Components]

### (Crosslinking Catalyst)

In the present invention, another crosslinking catalyst (Xc) may be added to the composition for forming a silicon-containing resist underlayer film in addition to the silicon-containing sulfonium salt compound represented by the above general formula (A-1). Examples of the crosslinking catalyst (Xc) that can be added include compounds represented by the following general formula (Xc0).

LₐH_{b}A (Xc0)

In the formula (Xc0), L represents lithium, sodium, potassium, rubidium, cesium, sulfonium, iodonium, phosphonium, or ammonium; A represents a non-nucleophilic counterion; and "a" represents an integer of 1 or more, "b" represents 0 or an integer of 1 or more, and a+b represents a valence number of the non-nucleophilic counterion.

Specific examples of the crosslinking catalyst (Xc) used as the compound represented by the specific general formula (Xc0) in the present invention include a sulfonium salt represented by the following general formula (Xc-1), an iodonium salt represented by the following general formula (Xc-2), a phosphonium salt represented by the following general formula (Xc-3), an ammonium salt represented by the following general formula (Xc-4), and an alkali metal salt.

Examples of a sulfonium salt (Xc-1), an iodonium salt (Xc-2), a phosphonium salt (Xc-3), and an ammonium salt (Xc-4) are exemplified as follow. 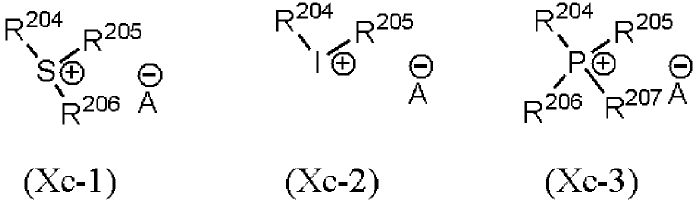 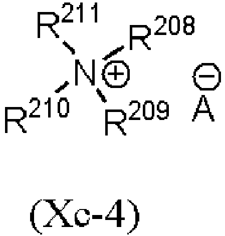 In the formulae, R²⁰⁴, R²⁰⁵, R²⁰⁶, and R²⁰⁷ each represent a linear, branched, or cyclic alkyl group, alkenyl group, oxoalkyl group, or oxoalkenyl group having 1 to 12 carbon atoms, a substituted or unsubstituted aryl group having 6 to 20 carbon atoms, or an aralkyl group or aryloxoalkyl group having 7 to 12 carbon atoms, and a part or all of hydrogen atoms in these groups may be substituted with an alkoxy group, etc.; R²⁰⁵ and R²⁰⁶ may form a ring, and when forming a ring, each of R²⁰⁵ and R²⁰⁶ represents an alkylene group having 1 to 6 carbon atoms; A⁻ represents the non-nucleophilic counterion; R²⁰⁸, R²⁰⁹, R²¹⁰, and R²¹¹ are same as R²⁰⁴, R²⁰⁵, R²⁰⁶, and R²⁰⁷, but may represent a hydrogen atom; and R²⁰⁸ and R²⁰⁹ or R²⁰⁸, R²⁰⁹, and R²¹⁰ may form a ring, and when forming a ring, R²⁰⁸ and R²⁰⁹ or R²⁰⁸, R²⁰⁹, and R²¹⁰ represent an alkylene group having 3 to 10 carbon atoms.

R²⁰⁴, R²⁰⁵, R²⁰⁶, R²⁰⁷, R²⁰⁸, R²⁰⁹, R²¹⁰, and R²¹¹ may be the same or different from each another. Specific examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, and an adamantyl group. Examples of the alkenyl group include a vinyl group, an allyl group, a propenyl group, a butenyl group, a hexenyl group, and a cyclohexenyl group. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, and a 2-(4-methylcyclohexyl)-2-oxoethyl group. Examples of the oxoalkenyl group include a 2-oxopropenyl group, a 2-oxobutenyl group, a 2-oxohexenyl group, a 2-oxocyclopentenyl group, and a 2-oxocyclohexenyl group. Examples of the aryl group include a phenyl group and a naphthyl group; alkoxyphenyl groups such as a p-methoxyphenyl group, a m-methoxyphenyl group, an o-methoxyphenyl group, an ethoxyphenyl group, a p-tert-butoxyphenyl group, and a m-tert-butoxyphenyl group; alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups such as a methylnaphthyl group and an ethylnaphthyl group; alkoxynaphthyl groups such as a methoxynaphthyl group and an ethoxynaphthyl group; dialkylnaphthyl groups such as a dimethylnaphthyl group and a diethylnaphthyl group; dialkoxynaphthyl groups such as a dimethoxynaphthyl group and a diethoxynaphthyl group. Examples of the aralkyl groups include a benzyl group, a phenylethyl group, and a phenethyl group. Examples of the aryloxoalkyl group include 2-aryl-2-oxoethyl groups such as a 2-phenyl-2-oxoethyl group, a 2-(1-naphthyl)-2-oxoethyl group, and a 2-(2-naphthyl)-2-oxoethyl group.

Examples of the non-nucleophilic counter ion A⁻include monovalent ions such as a hydroxide ion, a formate ion, an acetate ion, a propionate ion, a butanoate ion, a pentanoate ion, a hexanoate ion, heptanoate ion, an octanoate ion, a nonanoate ion, a decanoate ion, an oleate ion, a stearate ion, a linoleate ion, a linolenate ion, a benzoate ion, a phthalate ion, an isophthalate ion, a terephthalate ion, a salicylate ion, a trifluoroacetate ion, a monochloroacetate ion, a dichloroacetate ion, a trichloroacetate ion, a fluoride ion, a chloride ion, a bromide ion, an iodide ion, a nitrate ion, a nitrite ion, a chlorate ion, a bromate ion, a methanesulfonate ion, a paratoluenesulfonate ion, and a monomethylsulfate ion; and also include monovalent or divalent ions such as an oxalate ion, a malonate ion, a methylmalonate ion, an ethylmalonate ion, a propylmalonate ion, a butylmalonate ion, a dimethylmalonate ion, a diethylmalonate ion, a succinate ion, a methylsuccinate ion, a glutarate ion, an adipate ion, an itaconate ion, a maleate ion, a fumarate ion, a citraconate ion, a citrate ion, a carbonate ion, and a sulfate ion.

Examples of the alkali metal salt include monovalent salts such as hydroxide salts, formate salts, acetate salts, propionate salts, butanoate salts, pentanoate salts, hexanoate salts, heptanoate salts, octanoate salts, nonanoate salts, decanoate salts, oleate salts, stearate salts, linoleate salts, linolenate salts, benzoate salts, phthalate salts, isophthalate salts, terephthalate salts, salicylate salts, trifluoroacetate salts, monochloroacetate salts, dichloroacetate salts, and trichloroacetate salts; and monovalent or divalent salts such as oxalate salts, malonate salts, methylmalonate salts, ethylmalonate salts, propylmalonate salts, butylmalonate salts, dimethylmalonate salts, diethylmalonate salts, succinate salts, methylsuccinate salts, glutarate salts, adipate salts, itaconate salts, maleate salts, fumarate salts, citraconate salts, citrate salts, and carbonate salts, each of which is any salt of lithium, sodium, potassium, cesium, magnesium, and calcium.

Specific examples of the sulfonium salt (Xc-1) include a triphenylsulfonium formate, a triphenylsulfonium acetate, a triphenylsulfonium propionate, a triphenylsulfonium butanoate, a triphenylsulfonium benzoate, a triphenylsulfonium phthalate, a triphenylsulfonium isophthalate, a triphenylsulfonium terephthalate, a triphenylsulfonium salicylate, a triphenylsulfonium trifluoromethanesulfonate, a triphenylsulfonium trifluoroacetate, a triphenylsulfonium monochloroacetate, triphenylsulfonium dichloroacetate, a triphenylsulfonium trichloroacetate, a triphenylsulfonium hydroxide, a triphenylsulfonium nitrate, a triphenylsulfonium chloride, a triphenylsulfonium bromide, a triphenylsulfonium oxalate, a triphenylsulfonium malonate, a triphenylsulfonium methylmalonate, a triphenylsulfonium ethylmalonate, a triphenylsulfonium a propylmalonate, a triphenylsulfonium butylmalonate, a triphenylsulfonium dimethylmalonate, a triphenylsulfonium diethylmalonate, a triphenylsulfonium succinate, a triphenylsulfonium methylsuccinate, a triphenylsulfonium glutarate, a triphenylsulfonium adipate, a triphenylsulfonium itaconate, a triphenylsulfonium maleate, a triphenylsulfonium fumarate, a triphenylsulfonium citraconate, a triphenylsulfonium citrate, a triphenylsulfonium carbonate, a bistriphenylsulfonium oxalate, a bistriphenylsulfonium maleate, a bistriphenylsulfonium fumarate, a bistriphenylsulfonium citraconate, a bistriphenylsulfonium citrate, and a bistriphenylsulfonium carbonate.

Specific examples of the iodonium salt (Xc-2) include a diphenyliodonium formate, a diphenyliodonium acetate, a diphenyliodonium propionate, a diphenyliodonium butanoate, a diphenyliodonium benzoate, diphenyliodonium phthalate, a diphenyliodonium isophthalate, a diphenyliodonium terephthalate, a diphenyliodonium salicylate, a diphenyliodonium trifluoromethanesulfonate, a diphenyliodonium trifluoroacetate, a diphenyliodonium monochloroacetate, a diphenyliodonium dichloroacetate, a diphenyliodonium trichloroacetate, a diphenyliodonium hydroxide, a diphenyliodonium nitrate, a diphenyliodonium chloride, a diphenyliodonium bromide, a diphenyliodonium iodide, a diphenyliodonium oxalate, a diphenyliodonium maleate, a diphenyliodonium fumarate, a diphenyliodonium citraconate, a diphenyliodonium citrate, a diphenyliodonium carbonate, a bisdiphenyliodonium oxalate, a bisdiphenyliodonium maleate, a bisdiphenyliodonium fumarate, a bisdiphenyliodonium citraconate, a bisdiphenyliodonium citrate, and a bisdiphenyliodonium carbonate.

Specific examples of the phosphonium salt (Xc-3) include a tetraethylphosphonium formate, a tetraethylphosphonium acetate, a tetraethylphosphonium propionate, a tetraethylphosphonium butanoate, a tetraethylphosphonium benzoate, a tetraethylphosphonium phthalate, a tetraethylphosphonium isophthalate, a tetraethylphosphonium terephthalate, a tetraethylphosphonium salicylate, a tetraethylphosphonium trifluoromethanesulfonate, a tetraethylphosphonium trifluoroacetate, a tetraethylphosphonium monochloroacetate, a tetraethylphosphonium dichloroacetate, a tetraethylphosphonium trichloroacetate, a tetraethylphosphonium hydroxide, a tetraethylphosphonium nitrate, a tetraethylphosphonium chloride, a tetraethylphosphonium bromide, a tetraethylphosphonium iodide, a tetraethylphosphonium oxalate, a tetraethylphosphonium maleate, a tetraethylphosphonium fumarate, a tetraethylphosphonium citraconate, a tetraethylphosphonium citrate, a tetraethylphosphonium carbonate, a bistetraethylphosphonium oxalate, a bistetraethylphosphonium maleate, a bistetraethylphosphonium fumarate, a bistetraethylphosphonium citraconate, a bistetraethylphosphonium citrate, a bistetraethylphosphonium carbonate, a tetraphenylphosphonium formate, a tetraphenylphosphonium acetate, a tetraphenylphosphonium propionate, a tetraphenylphosphonium butanoate, a tetraphenylphosphonium benzoate, a tetraphenylphosphonium phthalate, a tetraphenylphosphonium isophthalate, a tetraphenylphosphonium terephthalate, a tetraphenylphosphonium salicylate, a tetraphenylphosphonium trifluoromethanesulfonate, a tetraphenylphosphonium trifluoroacetate, a tetraphenylphosphonium monochloroacetate, a tetraphenylphosphonium dichloroacetate, a tetraphenylphosphonium trichloroacetate, a tetraphenylphosphonium hydroxide, a tetraphenylphosphonium nitrate, a tetraphenylphosphonium chloride, a tetraphenylphosphonium bromide, a tetraphenylphosphonium iodide, a tetraphenylphosphonium oxalate, a tetraphenylphosphonium maleate, a tetraphenylphosphonium fumarate, a tetraphenylphosphonium citraconate, a tetraphenylphosphonium citrate, a tetraphenylphosphonium carbonate, a bistetraphenylphosphonium oxalate, a bistetraphenylphosphonium maleate, a bistetraphenylphosphonium fumarate, a bistetraphenylphosphonium citraconate, a bistetraphenylphosphonium citrate, and a bistetraphenylphosphonium carbonate.

Specific examples of the ammonium salt (Xc-4) include a tetramethylammonium formate, a tetramethylammonium acetate, a tetramethylammonium propionate, a tetramethylammonium butanoate, a tetramethylammonium benzoate, a tetramethylammonium phthalate, a tetramethylammonium isophthalate, a tetramethylammonium terephthalate, a tetramethylammonium salicylate, a tetramethylammonium trifluoromethanesulfonate, a tetramethylammonium trifluoroacetate, a tetramethylammonium monochloroacetate, a tetramethylammonium dichloroacetate, a tetramethylammonium trichloroacetate, a tetramethylammonium hydroxide, a tetramethylammonium nitrate, a tetramethylammonium chloride, a tetramethylammonium bromide, a tetramethylammonium iodide, a tetramethylammonium monomethylsulfate, a tetramethylammonium oxalate, a tetramethylammonium malonate, a tetramethylammonium maleate, a tetramethylammonium fumarate, a tetramethylammonium citraconate, a tetramethylammonium citrate, a tetramethylammonium carbonate, a bistetramethylammonium oxalate, a bistetramethylammonium malonate, a bistetramethylammonium maleate, a bistetramethylammonium fumarate, a bistetramethylammonium citraconate, a bistetramethylammonium citrate, a bistetramethylammonium carbonate, a tetraethylammonium formate, a tetraethylammonium acetate, a tetraethylammonium propionate, a tetraethylammonium butanoate, a tetraethylammonium benzoate, a tetraethylammonium phthalate, a tetraethylammonium isophthalate, a tetraethylammonium terephthalate, a tetraethylammonium salicylate, a tetraethylammonium trifluoromethanesulfonate, a tetraethylammonium trifluoroacetate, a tetraethylammonium monochloroacetate, a tetraethylammonium dichloroacetate, a tetraethylammonium trichloroacetate, a tetraethylammonium hydroxide, a tetraethylammonium nitrate, a tetraethylammonium chloride, a tetraethylammonium bromide, a tetraethylammonium iodide, a tetraethylammonium monomethylsulfate, a tetraethylammonium oxalate, a tetraethylammonium malonate, a tetraethylammonium maleate, a tetraethylammonium fumarate, a tetraethylammonium citraconate, a tetraethylammonium citrate, a tetraethylammonium carbonate, a bistetraethylammonium oxalate, a bistetraethylammonium malonate, a bistetraethylammonium maleate, a bistetraethylammonium fumarate, a bistetraethylammonium citraconate, a bistetraethylammonium citrate, a bistetraethylammonium carbonate, a tetrapropylammonium formate, a tetrapropylammonium acetate, a tetrapropylammonium propionate, a tetrapropylammonium butanoate, a tetrapropylammonium benzoate, a tetrapropylammonium phthalate, a tetrapropylammonium isophthalate, a tetrapropylammonium terephthalate, a tetrapropylammonium salicylate, a tetrapropylammonium trifluoromethanesulfonate, a tetrapropylammonium trifluoroacetate, a tetrapropylammonium monochloroacetate, a tetrapropylammonium dichloroacetate, a tetrapropylammonium trichloroacetate, a tetrapropylammonium hydroxide, a tetrapropylammonium nitrate, a tetrapropylammonium chloride, a tetrapropylammonium bromide, a tetrapropylammonium iodide, a tetrapropylammonium monomethylsulfate, a tetrapropylammonium oxalate, a tetrapropylammonium malonate, a tetrapropylammonium maleate, a tetrapropylammonium fumarate, a tetrapropylammonium citraconate, a tetrapropylammonium citrate, a tetrapropylammonium carbonate, a bistetrapropylammonium oxalate, a bistetrapropylammonium malonate, a bistetrapropylammonium maleate, a bistetrapropylammonium fumarate, a bistetrapropylammonium citraconate, a bistetrapropylammonium citrate, a bistetrapropylammonium carbonate, a tetrabutylammonium formate, a tetrabutylammonium acetate, a tetrabutylammonium propionate, a tetrabutylammonium butanoate, a tetrabutylammonium benzoate, a tetrabutylammonium phthalate, a tetrabutylammonium isophthalate, a tetrabutylammonium terephthalate, a tetrabutylammonium salicylate, a tetrabutylammonium trifluoromethanesulfonate, a tetrabutylammonium trifluoroacetate, a tetrabutylammonium monochloroacetate, a tetrabutylammonium dichloroacetate, a tetrabutylammonium trichloroacetate, a tetrabutylammonium hydroxide, a tetrabutylammonium nitrate, a tetrabutylammonium chloride, a tetrabutylammonium bromide, a tetrabutylammonium iodide, a tetrabutylammonium methanesulfonate, a tetrabutylammonium monomethylsulfate, a tetrabutylammonium oxalate, a tetrabutylammonium malonate, a tetrabutylammonium maleate, a tetrabutylammonium fumarate, a tetrabutylammonium citraconate, a tetrabutylammonium citrate, a tetrabutylammonium carbonate, a bistetrabutylammonium oxalate, a bistetrabutylammonium malonate, a bistetrabutylammonium maleate, a bistetrabutylammonium fumarate, a bistetrabutylammonium citraconate, a bistetrabutylammonium citrate, and a bistetrabutylammonium carbonate.

Examples of the alkaline metal salt include lithium formate, a lithium acetate, a lithium propionate, a lithium butanoate, a lithium benzoate, a lithium phthalate, a lithium isophthalate, a lithium terephthalate, a lithium salicylate, a lithium trifluoromethanesulfonate, a lithium trifluoroacetate, a lithium monochloroacetate, a lithium dichloroacetate, a lithium trichloroacetate, a lithium hydroxide, a lithium nitrate, a lithium chloride, a lithium bromide, a lithium iodide, a lithium methanesulfonate, a lithium hydrogen oxalate, a lithium hydrogen malonate, a lithium hydrogen maleate, a lithium hydrogen fumarate, a lithium hydrogen citraconate, a lithium hydrogen citrate, a lithium hydrogen carbonate, a lithium oxalate, a lithium malonate, a lithium maleate, a lithium fumarate, a lithium citraconate, a lithium citrate, a lithium carbonate, a sodium formate, a sodium acetate, a sodium propionate, a sodium butanoate, a sodium benzoate, a sodium phthalate, a sodium isophthalate, a sodium terephthalate, a sodium salicylate, a sodium trifluoromethanesulfonate, a sodium trifluoroacetate, a sodium monochloroacetate, a sodium dichloroacetate, a sodium trichloroacetate, a sodium hydroxide, a sodium nitrate, a sodium chloride, a sodium bromide, a sodium iodide, a sodium methanesulfonate, a sodium hydrogen oxalate, a sodium hydrogen malonate, a sodium hydrogen maleate, a sodium hydrogen fumarate, a sodium hydrogen citraconate, a sodium hydrogen citrate, a sodium hydrogen carbonate, a sodium oxalate, a sodium malonate, a sodium maleate, a sodium fumarate, a sodium citraconate, a sodium citrate, a sodium carbonate, a potassium formate, a potassium acetate, a potassium propionate, a potassium butanoate, a potassium benzoate, a potassium phthalate, a potassium isophthalate, a potassium terephthalate, a potassium salicylate, a potassium trifluoromethanesulfonate, a potassium trifluoroacetate, a potassium monochloroacetate, a potassium dichloroacetate, a potassium trichloroacetate, a potassium hydroxide, a potassium nitrate, a potassium chloride, a potassium bromide, a potassium iodide, a potassium methanesulfonate, a potassium hydrogen oxalate, a potassium hydrogen malonate, a potassium hydrogen maleate, a potassium hydrogen fumarate, a potassium hydrogen citraconate, a potassium hydrogen citrate, a potassium hydrogen carbonate, a potassium oxalate, a potassium malonate, a potassium maleate, a potassium fumarate, a potassium citraconate, a potassium citrate, and a potassium carbonate.

In the present invention, a polysiloxane (Xc-10) having the ammonium salt, the sulfonium salt, the phosphonium salt, or the iodonium salt as a partial structure may be blended as the crosslinking catalyst (Xc) into the composition for forming a resist underlayer film.

As a material for producing (Xc-10) used here, a compound represented by the following formula (Xm) can be used.

R^{1A}_{A1}R^{2A}_{A2}R^{3A}_{A3}Si(OR^{0A})_{(4-A1-A2-A3)} (Xm)

In the formula (Xm), R^{0A} represents a hydrocarbon group having 1 to 6 carbon atoms; at least one of R^{1A}, R^{2A}, and R^{3A} represents an organic group having an ammonium salt, a sulfonium salt, a phosphonium salt, or an iodonium salt and the other (s) of R^{1A}, R^{2A}, and R^{3A} represent a hydrogen atom or a monovalent organic group having 1 to 30 carbon atoms; and A1, A2, and A3 each represent 0 or 1, given that 1≤A1+A2+A3≤3.

Here, examples of R^{0A} include a methyl group, an ethyl group, an n-propyl group, an iso-propyl group, an n-butyl group, an iso-butyl group, a sec-butyl group, a tert-butyl group, an n-pentyl group, a cyclopentyl group, an n-hexyl group, a cyclohexyl group, and a phenyl group.

Example of Xm includes compounds represented by the following general formula (Xm-1), which is a hydrolysable silicon compound having a sulfonium salt as a partial structure.

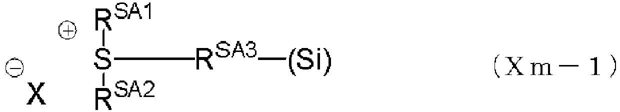

In the formula (Xm-1), R^{SA1} and R^{SA2} each represent a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or aryloxyalkyl group having 7 to 20 carbon atoms; some or all of hydrogen atoms of these groups are optionally substituted with an alkoxy group, an amino group, an alkylamino group, a halogen atom, or the like; R^{SA1} and R^{SA2} may form a ring together with a sulfur atom bonded to R^{SA1} and R^{SA2}, when a ring is formed, R^{SA1} and R^{SA2} each represent an alkylene group having 1 to 6 carbon atoms. R^{SA3} represents a linear, branched, or cyclic alkylene group or alkenylene group having 1 to 20 carbon atoms, or a substituted or unsubstituted arylene group having 6 to 20 carbon atoms; some or all of hydrogen atoms of these groups are optionally substituted with an alkoxy group, an amino group, an alkylamino group, or the like.

Incidentally, in the above general formula (Xm-1), (Si) was described to indicate an attachment point to an Si atom.

Examples of X⁻ include a hydroxide ion, a fluoride ion, a chloride ion, a bromide ion, an iodide ion, formate ion, an acetate ion, a propionate ion, a butanoate ion, a pentanoate ion, a hexanoate ion, heptanoate ion, an octanoate ion, a nonanoate ion, a decanoate ion, an oleate ion, a stearate ion, a linoleate ion, a linolenate ion, a benzoate ion, a p-methylbenzoate ion, a p-t-butylbenzoate ion, a phthalate ion, an isophthalate ion, a terephthalate ion, a salicylate ion, a trifluoroacetate ion, a monochloroacetate ion, a dichloroacetate ion, a trichloroacetate ion, a nitrate ion, a chlorate ion, a perchlorate ion, a bromate ion, an iodate ion, a methanesulfonate ion, a benzenesulfonate ion, a toluenesulfonate ion, a monomethylsulfate ion, a hydrogen sulfate ion, an oxalate ion, a malonate ion, a methylmalonate ion, an ethylmalonate ion, a propylmalonate ion, a butylmalonate ion, a dimethylmalonate ion, a diethylmalonate ion, a succinate ion, a methylsuccinate ion, a glutarate ion, an adipate ion, an itaconate ion, a maleate ion, a fumarate ion, a citraconate ion, a citrate ion, and a carbonate ion.

Specific examples of the cation moiety of the compound represented by the above general formula (Xm-1) include the following ions.

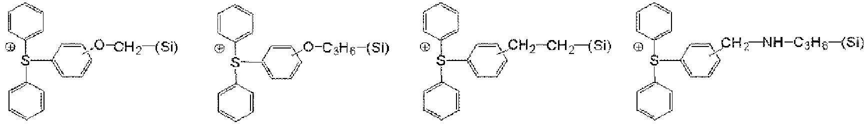

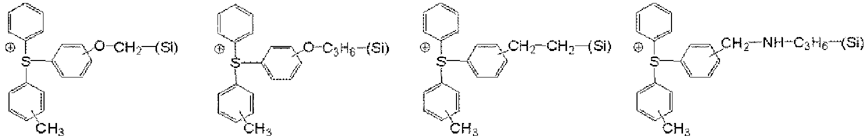

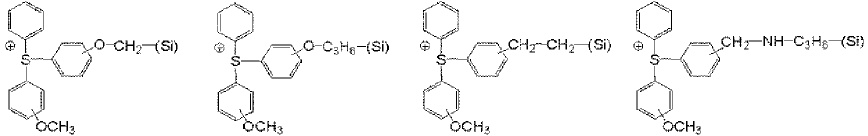

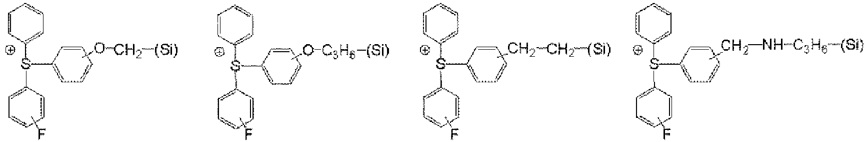

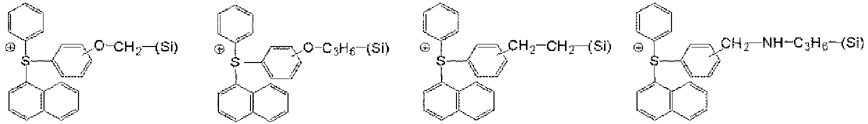

As Xm, examples of a hydrolysable silicon compound having the iodonium salt as a partial structure include compounds represented by the following general formula (Xm-2).

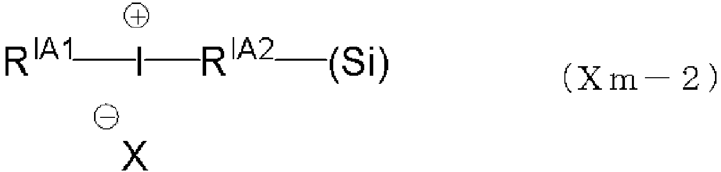

In the formula (Xm-2), R^{IA1} represents a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or aryloxoalkyl group having 7 to 20 carbon atoms; some or all of hydrogen atoms of these groups are optionally substituted with an alkoxy group, an amino group, an alkylamino group, a halogen atom, or the like; and R^{IA2} represents a linear, branched, or cyclic alkylene group or alkenylene group having 1 to 20 carbon atoms, or a substituted or unsubstituted arylene group having 6 to 20 carbon atoms; some or all of hydrogen atoms of these groups are optionally substituted with an alkoxy group, an amino group, an alkylamino group, or the like.

Incidentally, in the above general formula (Xm-2), (Si) was described to indicate an attachment point to an Si atom. X is the same as defined above.

Specific examples of the cation moiety of the compound represented by the above general formula (Xm-2) include the following ions.

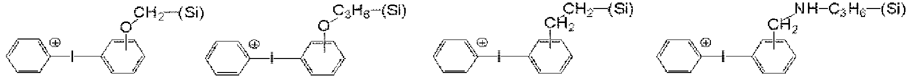

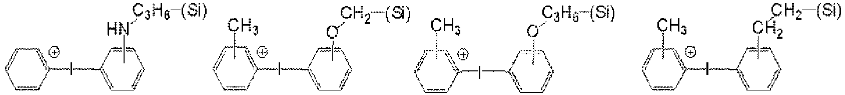

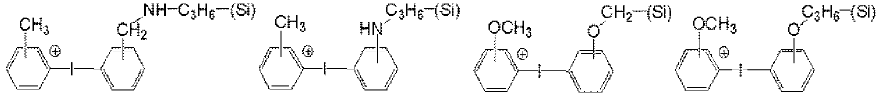

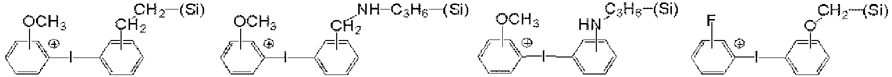

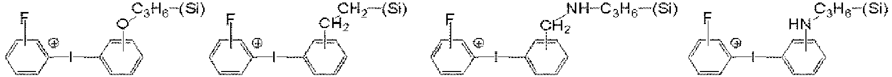

As Xm, examples of a hydrolysable silicon compound having the phosphonium salt as a partial structure include compounds represented by the following general formula (Xm-3).

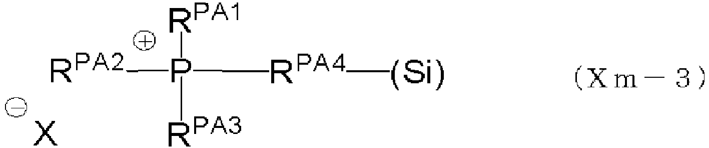

In the formula (Xm-3), R^{PA1}, R^{PA2}, and R^{PA3} each represent a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or aryloxoalkyl group having 7 to 20 carbon atoms; some or all of hydrogen atoms of these groups are optionally substituted with an alkoxy group, an amino group, an alkylamino group, a halogen atom, or the like; and R^{PA1} and R^{PA2} may form a ring together with a phosphorus atom bonded to R^{PA1} and R^{PA2}, and when a ring is formed, R^{PA1} and R^{PA2} each represent an alkylene group having 1 to 6 carbon atoms. R^{PA4} represents a linear, branched, or cyclic alkylene group or alkenylene group having 1 to 20 carbon atoms, or a substituted or unsubstituted arylene group having 6 to 20 carbon atoms; some or all of hydrogen atoms of these groups are optionally substituted with an alkoxy group, an amino group, an alkylamino group, or the like.

Incidentally, in the above general formula (Xm-3), (Si) was described to indicate an attachment point to an Si atom. X is the same as defined above.

Specific examples of the cation moiety of the compound represented by the above general formula (Xm-3) include the following ions.

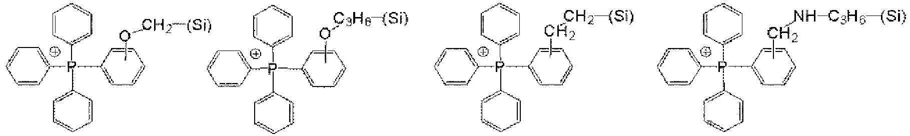

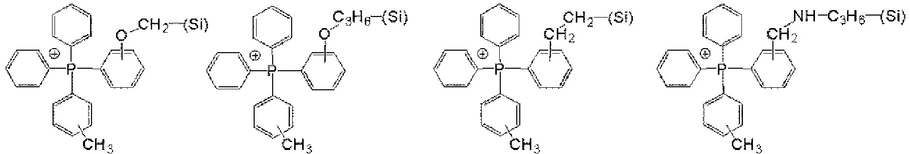

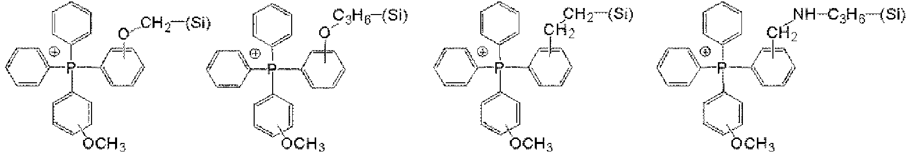

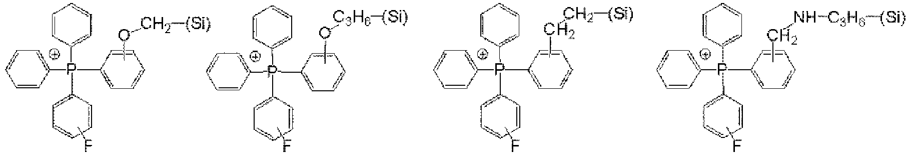

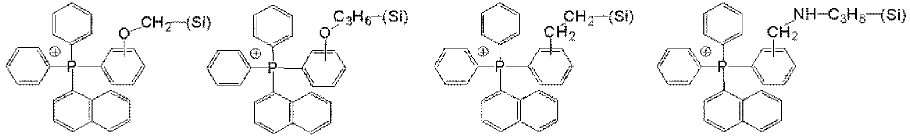

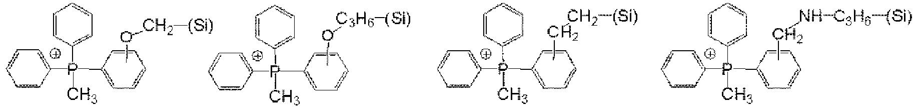

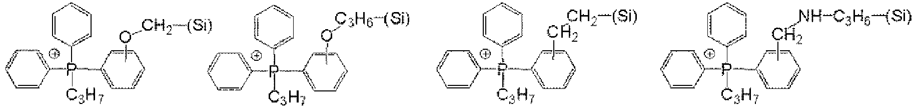

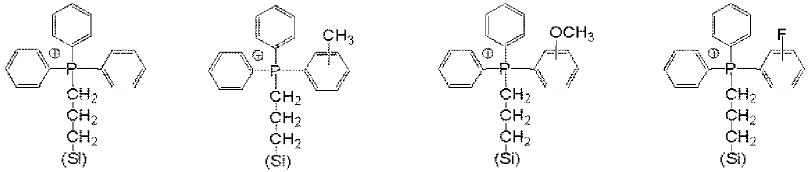

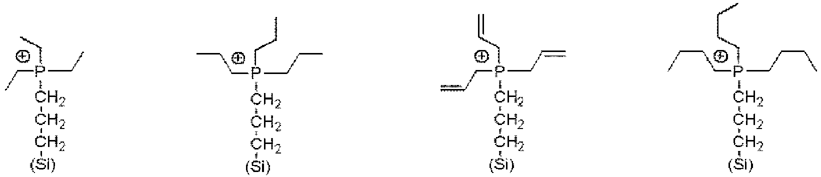

As Xm, examples of a hydrolysable silicon compound having an ammonium salt as a partial structure include compounds represented by the following general formula (Xm-4).

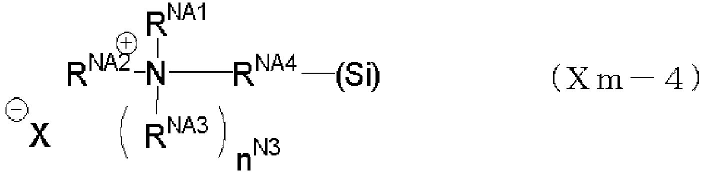

In the formula (Xm-4), R^{NA1}, R^{NA2}, and R^{NA3} each represent a linear, branched, or cyclic alkyl group, alkenyl group, oxoalkyl group, or oxoalkenyl group having 1 to 20 carbon atoms, a substituted or unsubstituted aryl group having 6 to 20 carbon atoms, or an aralkyl group or aryloxyalkyl group having 7 to 20 carbon atoms; some or all of hydrogen atoms of these groups are optionally substituted with an alkoxy group, an amino group, an alkylamino group, or the like; and R^{NA1} and R^{NA2} may form a ring together with a nitrogen atom bonded to R^{NA1} and R^{NA2}, and when a ring is formed, R^{NA1} and R^{NA2} each represent an alkylene group having 1 to 6 carbon atoms or a heterocyclic ring or heteroaromatic ring containing nitrogen. R^{NA4} represents a linear, branched, or cyclic alkylene group or alkenylene group having 1 to 20 carbon atoms, or a substituted or unsubstituted arylene group having 6 to 20 carbon atoms and some or all of hydrogen atoms of these groups are optionally substituted with an alkoxy group, an amino group, an alkylamino group, or the like. In the case where R^{NA1} and R^{NA2}, or R^{NA1} and R^{NA4}, form a cyclic structure which further contains unsaturated nitrogen, n^{N3}=0, and in the other cases, n^{N3}=1.

Incidentally, in the above general formula (Xm-4), (Si) was described to indicate an attachment point to an Si atom. X is the same as defined above.

Specific examples of the cation moiety of the compound represented by the above general formula (Xm-4) include the following ions.

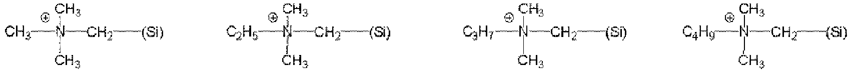

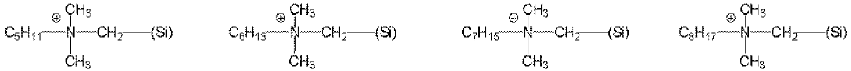

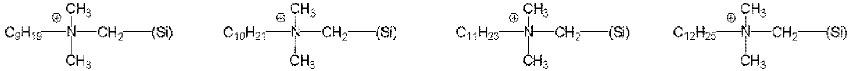

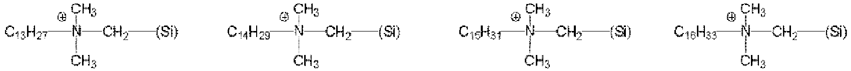

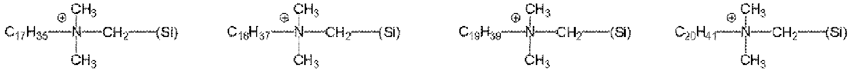

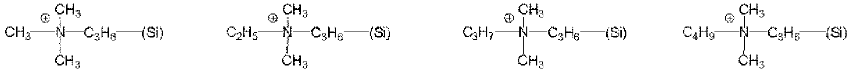

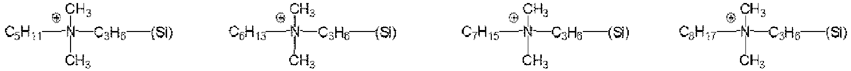

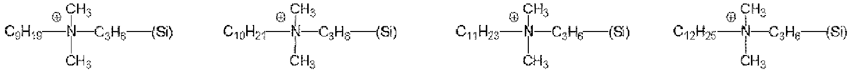

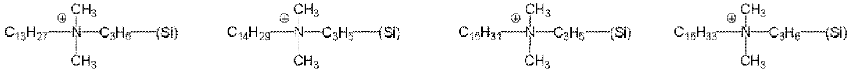

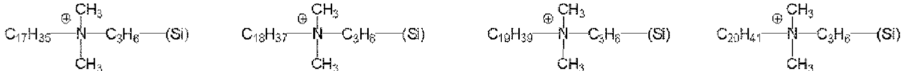

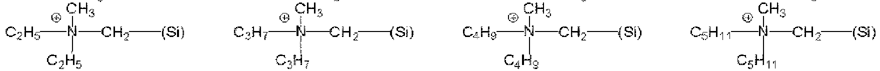

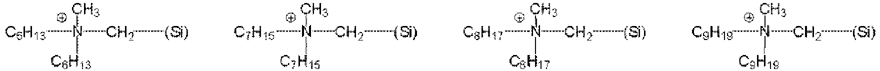

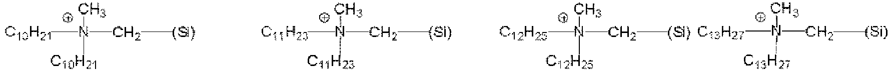

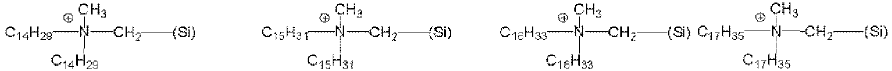

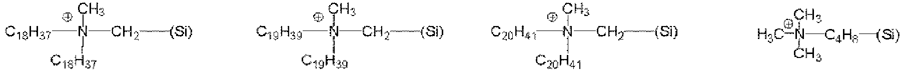

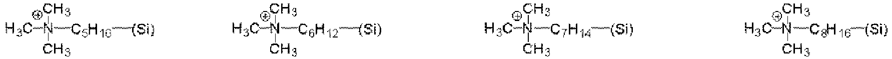

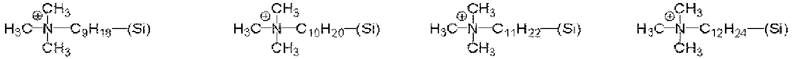

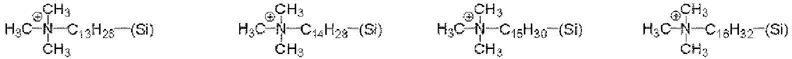

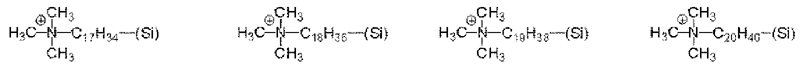

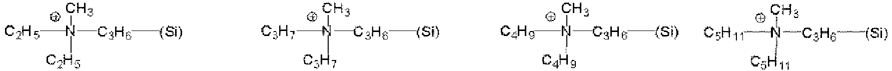

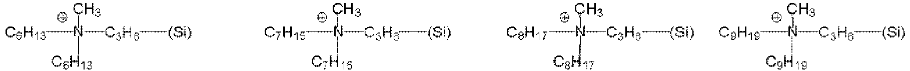

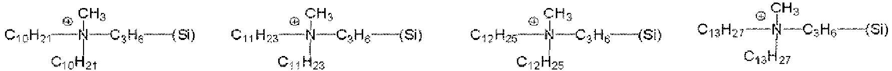

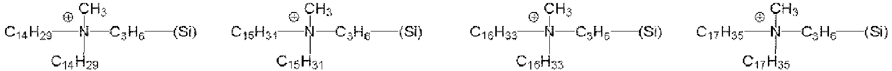

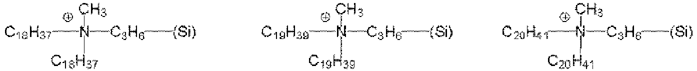

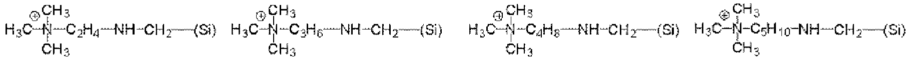

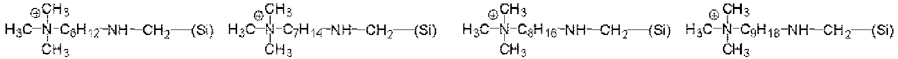

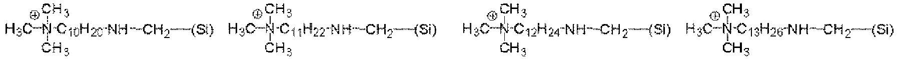

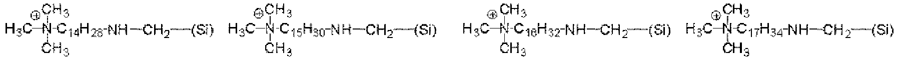

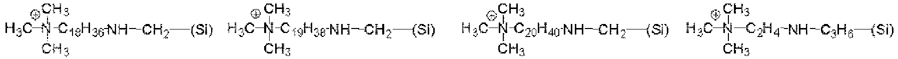

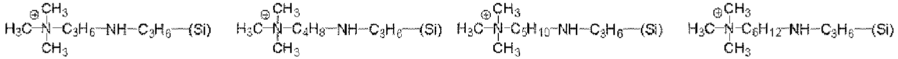

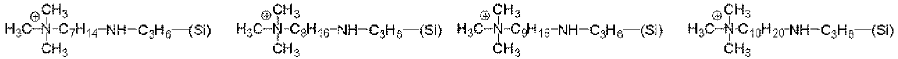

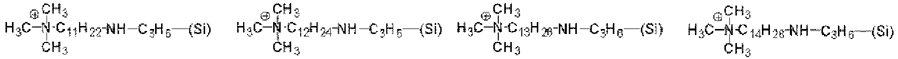

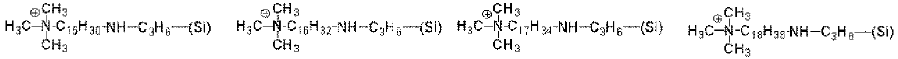

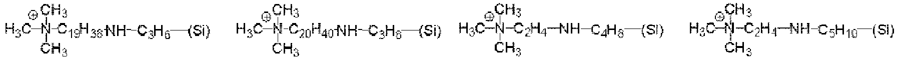

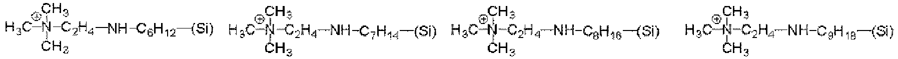

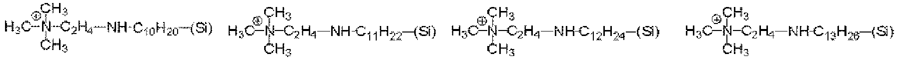

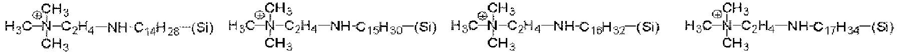

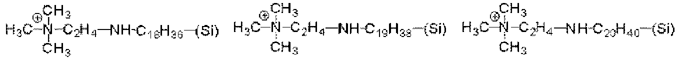

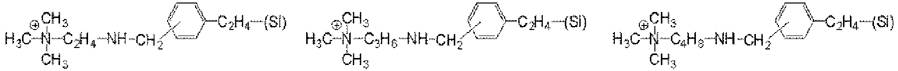

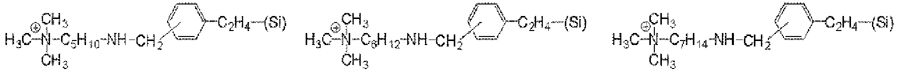

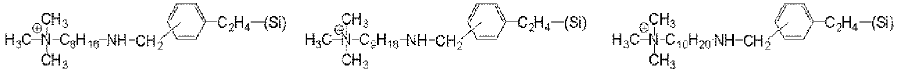

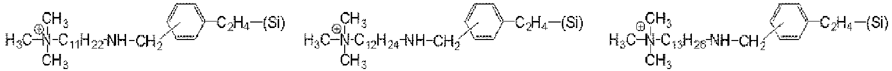

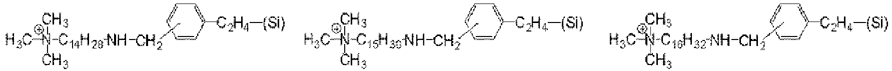

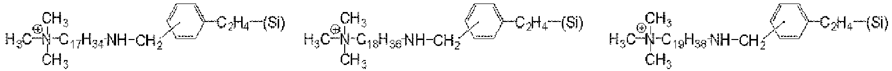

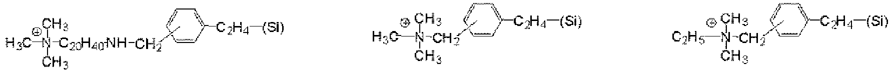

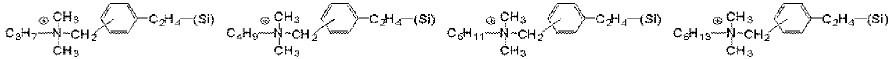

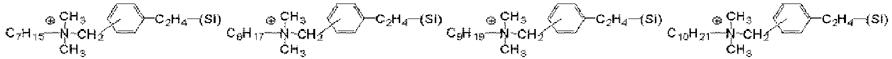

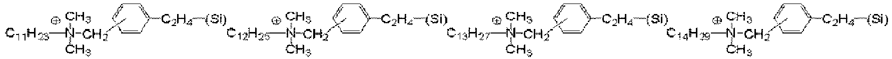

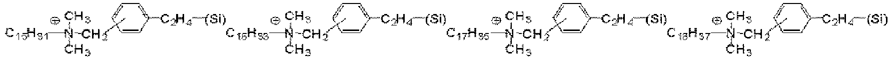

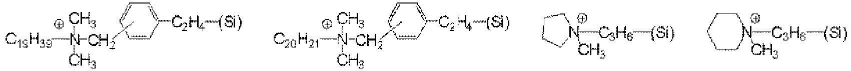

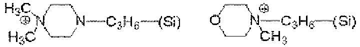

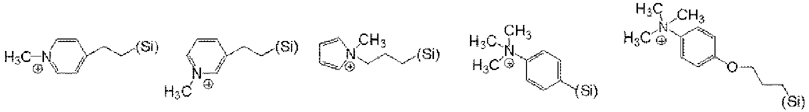

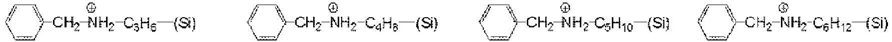

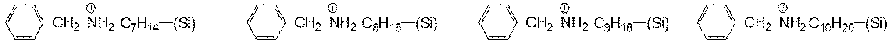

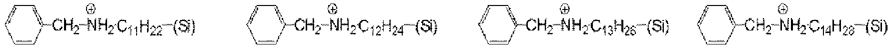

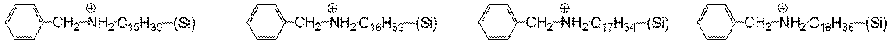

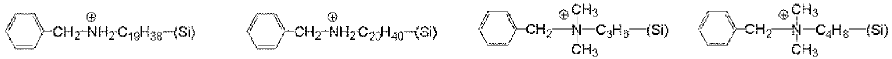

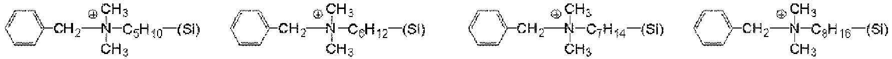

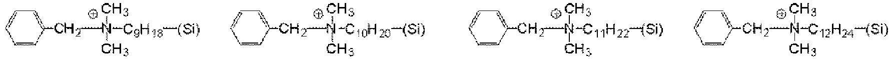

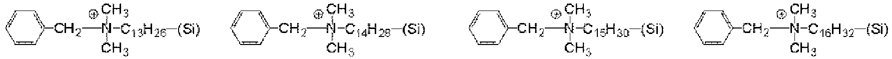

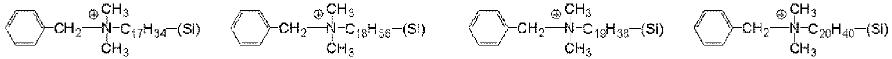

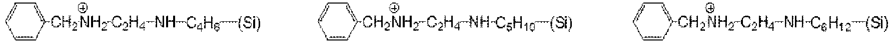

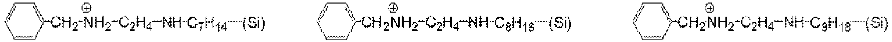

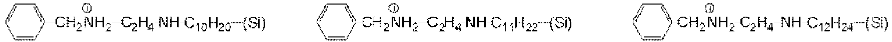

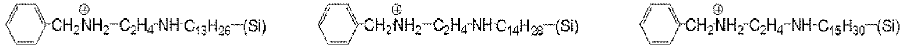

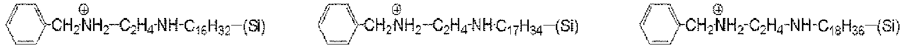

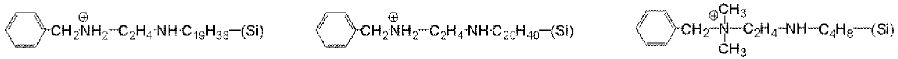

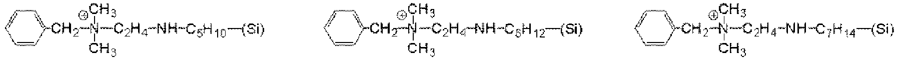

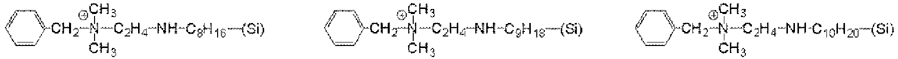

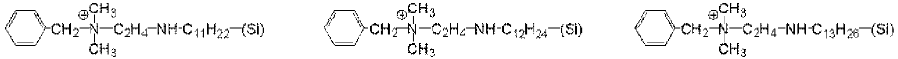

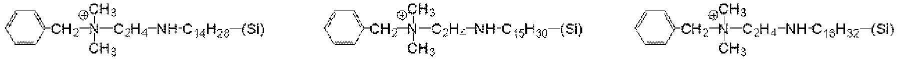

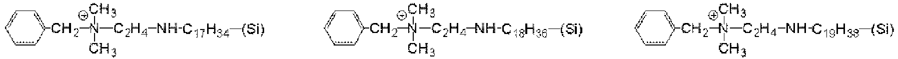

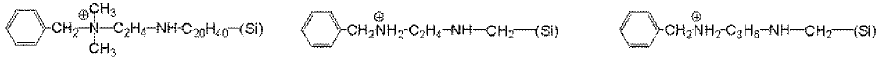

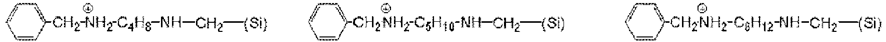

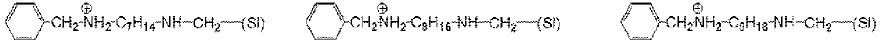

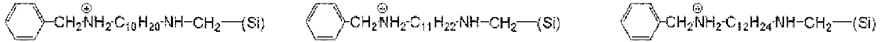

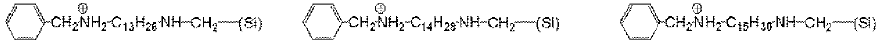

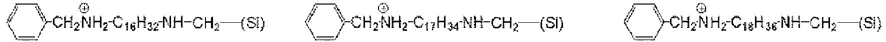

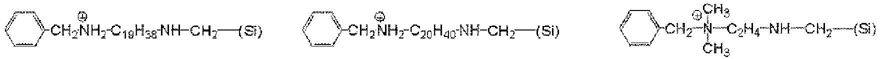

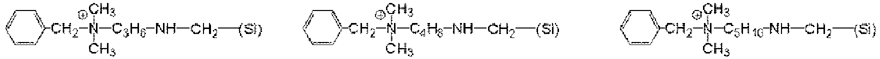

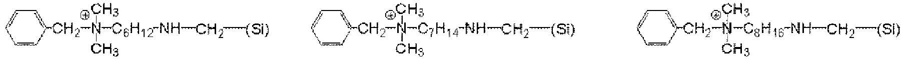

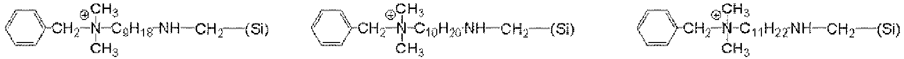

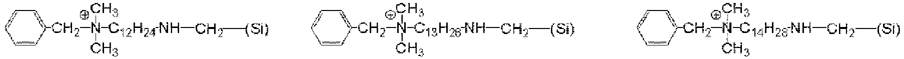

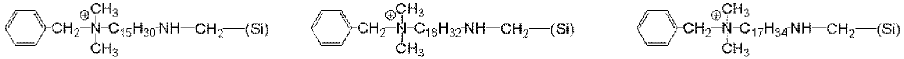

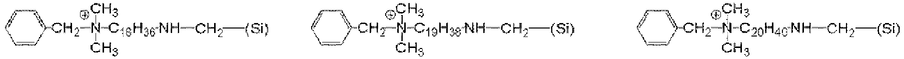

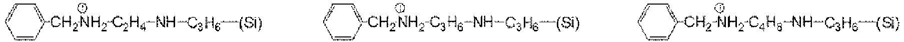

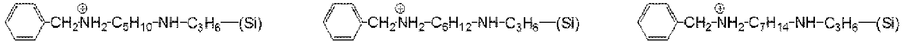

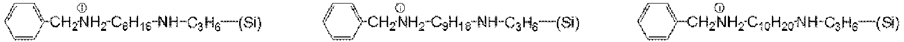

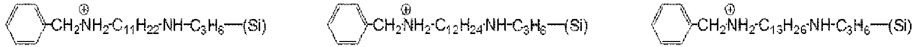

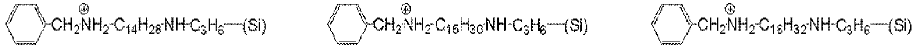

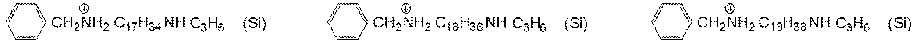

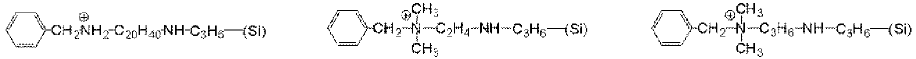

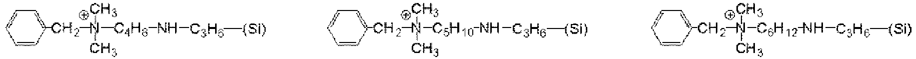

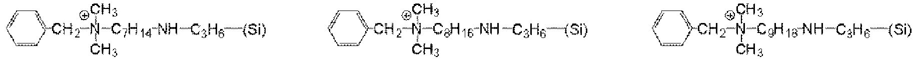

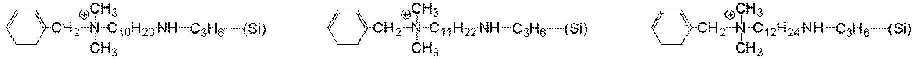

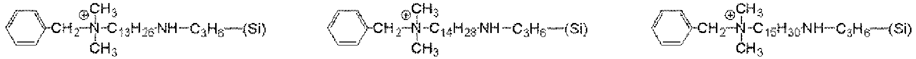

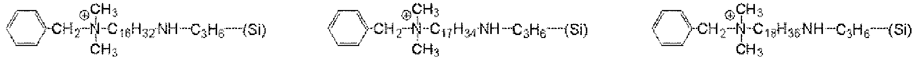

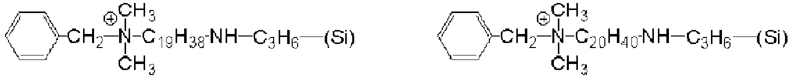

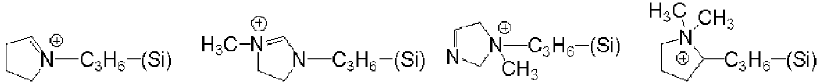

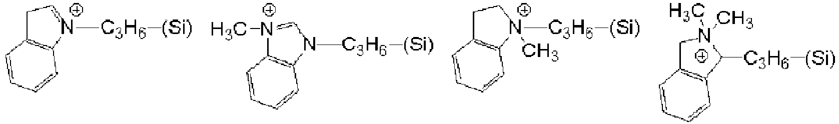

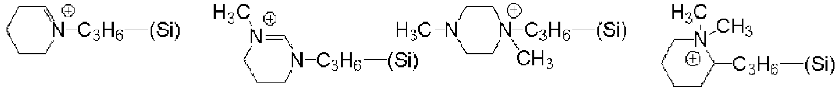

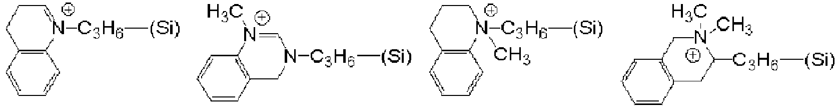

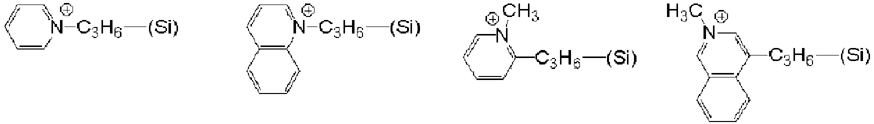

Examples of the hydrolysable silicon compound used together with the above (Xm-1), (Xm-2), (Xm-3), and (Xm-4) for manufacturing (Xc-10) include the above hydrolyzable monomer (Sm). Further, the hydrolyzable metal compound represented by the above general formula (Mm) may be added.

One or more of the monomers (Xm-1), (Xm-2), (Xm-3), and (Xm-4) as described above, one or more (Sm), and one or more (Mm) if necessary, further, may be selected and mixed before or during the reaction to be prepared as the reaction material to form (Xc-10). The reaction condition may be the same as the synthetic method of the thermally crosslinkable polysiloxane (Sx).

The molecular weight of the crosslinking catalyst (Xc-10) to be obtained can be adjusted not only through the selection of the monomers but also by controlling the reaction conditions during the polymerization. When the weight average molecular weight is not more than 100,000, foreign matters or coating spots are not generated. Thus, it is preferable to use the crosslinking catalyst having a weight average molecular weight of 100,000 or less, more preferably 200 to 50,000, further preferably 300 to 30,000. Incidentally, data on the above weight-average molecular weight indicate the molecular weight in terms of polystyrene by gel permeation chromatography (GPC) using tetrahydrofuran as an eluent solvent, using RI as a detector, and using polystyrene as a standard substance.

One of the crosslinking catalysts (Xc-1), (Xc-2), (Xc-3), (Xc-4), and (Xc-10) may be used alone, or two or more thereof may be used in combination. The amount of the crosslinking catalyst to be added is preferably 0.01 to 50 parts by mass, more preferably 0.1 to 40 parts by mass, relative to 100 parts by mass of the base polymer (the thermally crosslinkable polysiloxane (Sx) obtained by the above method).

### (Organic Acid)

To improve the stability of the inventive composition for forming a silicon-containing resist underlayer film, it is preferable to add a monovalent, divalent, or more polyvalent organic acid having 1 to 30 carbon atoms. Examples of the acid added in this event include a formic acid, an acetic acid, a propionic acid, a butanoic acid, a pentanoic acid, a hexanoic acid, a heptanoic acid, an octanoic acid, a nonanoic acid, a decanoic acid, an oleic acid, a stearic acid, a linoleic acid, a linolenic acid, a benzoic acid, a phthalic acid, an isophthalic acid, a terephthalic acid, a salicylic acid, a trifluoroacetic acid, a monochloroacetic acid, a dichloroacetic acid, a trichloroacetic acid, an oxalic acid, a malonic acid, a methylmalonic acid, an ethylmalonic acid, a propylmalonic acid, a butylmalonic acid, a dimethylmalonic acid, a diethylmalonic acid, a succinic acid, a methylsuccinic acid, a glutaric acid, an adipic acid, an itaconic acid, a maleic acid, a fumaric acid, a citraconic acid, and a citric acid. An oxalic acid, a maleic acid, a formic acid, an acetic acid, a propionic acid, and a citric acid are particularly preferable. Moreover, a mixture of two or more acids may be used to keep the stability. The amount of the organic acid to be added may be preferably 0.001 to 25 parts by mass, more preferably 0.01 to 15 parts by mass, and further preferably 0.1 to 5 parts by mass, relative to 100 parts by mass of silicon contained in the inventive composition for forming a silicon-containing resist underlayer film.

Otherwise, the organic acid(s) may be blended based on the pH of the composition for forming a silicon-containing resist underlayer film so as to satisfy preferably 0≤pH≤7, more preferably 0.3≤pH≤6.5, further preferably 0.5≤pH≤6.

### (Water)

In the present invention, water may be added to the composition for forming a silicon-containing resist underlayer film. When water is added, the polysiloxane compound in the inventive composition for forming a silicon-containing resist underlayer film is hydrated, so that the lithography performance is improved. The water content in the solvent component of the inventive composition for forming a silicon-containing resist underlayer film is preferably more than 0 mass% and less than 50 mass%, more preferably 0.3 to 30 mass%, further preferably 0.5 to 20 mass%. When the amount of water added is less than 50 mass%, a silicon-containing resist underlayer film has good uniformity, and repelling does not occur. Meanwhile, when the amount of water to be added exceeds 0 mass%, the lithography performance is good.

The total amount of solvent(s) to be used including water is preferably 100 to 100,000 parts by mass, particularly preferably 200 to 50,000 parts by mass, relative to 100 parts by mass of the thermally crosslinkable polysiloxane, which is the base polymer.

### (Stabilizer)

Further, in the present invention, a stabilizer may be added to the composition for forming a silicon-containing resist underlayer film. As the stabilizer, a monohydric, dihydric, or more polyhydric alcohol having cyclic ether as a substituent can be added. Particularly, adding stabilizers disclosed in paragraphs [0181] to [0182] of JP2009-126940A can improve stability of the inventive composition for forming a silicon-containing resist underlayer film. The blending amount of the stabilizer is preferably 0 to 50 parts by mass, more preferably 0 to 40 parts by mass relative to 100 parts by mass of the thermally crosslinkable polysiloxane (Sx), which is the base polymer.

### (Surfactant)

Further, in the present invention, a surfactant may be blended into the composition for forming a silicon-containing resist underlayer film as necessary. Specifically for such a surfactant, it is possible to add the materials disclosed in paragraph [0185] of JP2009-126940A. The blending amount of the surfactant is preferably 0 to 10 parts by mass, more preferably 0-5 parts by mass relative to 100 parts by mass of the thermally crosslinkable polysiloxane (Sx), which is the base polymer.

### (High-Boiling-Point Solvent)

Further, in the present invention, a high-boiling-point solvent having a boiling point of 180°C or more may also be added to the composition as necessary. Examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, gamma-butyrolactone, tripropylene glycol monomethyl ether, diacetone alcohol, n-nonyl acetate, ethylene glycol monoethyl ether acetate, 1,2-diacetoxyethane, 1-acetoxy-2-methoxyethane, 1,2-diacetoxypropane, diethylene glycol monomethyl ether acetate, diethylene glycol monoethyl ether acetate, diethylene glycol mono-n-butyl ether acetate, propylene glycol monomethyl ether acetate, propylene glycol monopropyl ether acetate, propylene glycol monobutyl ether acetate, dipropylene glycol monomethyl ether acetate, and dipropylene glycol monoethyl ether acetate. The blending amount of the high-boiling-point solvent is preferably 0 to 20 mass%, more preferably 0 to 10 mass% as a percentage in the solvent component.

### [Patterning Process]

One of the inventive patterning process is a method (what is called "multilayer resist method") to form a pattern in a body to be processed, which includes the steps of:
forming an organic film on a body to be processed by using a coating-type material for an organic film;
forming a silicon-containing resist underlayer film on the organic film by using the composition for forming a silicon-containing resist underlayer film described above;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask;
transferring the pattern to the organic film by etching while using the silicon-containing resist underlayer film having the transferred pattern as a mask; and
transferring the pattern to the body to be processed by etching while using the organic film having the transferred pattern as a mask.

One of the inventive patterning process is a method (what is called "multilayer resist method") to form a pattern in a body to be processed, which includes the steps of:
forming a hard mask on a body to be processed by a CVD method;
forming a silicon-containing resist underlayer film on the hard mask by using the composition for forming a silicon-containing resist underlayer film described above;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask;
transferring the pattern to the hard mask by dry etching while using the silicon-containing resist underlayer film having the transferred pattern as a mask; and
transferring the pattern to the body to be processed by dry etching while using the hard mask having the transferred pattern as a mask.

One of the inventive patterning process is a method (what is called "multilayer resist method") to form a pattern in a body to be processed, which includes the steps of:
forming a silicon-containing resist underlayer film on a body to be processed by using the composition for forming a silicon-containing resist underlayer film described above;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask; and
transferring the pattern to the body to be processed by etching while using the silicon-containing resist underlayer film having the transferred pattern as a mask.

The pattern, which was obtained by blending the inventive silicon-containing sulfonium salt compound into a composition for forming a silicon-containing resist underlayer film, can be formed on a substrate as a fine pattern having excellent LWR and CDU by optimizing the combination of a hard mask and an organic film as described above. In addition, because the silicon-containing resist underlayer film remaining after pattern formation can be easily removed by etching, etc., it is possible to reduce the residue that causes defects, and also prevent damage to the substrate due to an excessive etching conditions.

In the positive-type patterning method, the photoresist film (resist upper layer film) is formed, subjected to a heating treatment, then exposed to light, and followed by alkali development using typically an alkali developer to obtain the positive-type resist pattern. Further, after the exposure, it is preferable to perform post exposure baking (PEB).

As the alkali developer, an aqueous solution of tetramethylammonium hydroxide (TMAH), etc. may be used.

As the patterning process, a circuit pattern is formed in the resist upper layer film preferably by photolithography using a light having a wavelength of 10 nm or more and 300 nm or less, direct drawing by an electron beam, nanoimprinting, or a combination thereof.

The body to be processed is preferably a semiconductor device substrate or the semiconductor device substrate coated with any of a metal film, a metal carbide film, a metal oxide film, a metal nitride film, a metal oxycarbide film, and a metal oxynitride film.

The metal to be used is preferably silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

### EXAMPLE

Hereinafter, the present invention will be specifically described with reference to Synthesis Examples, Comparative Synthesis Examples, Examples and Comparative Examples. However, the present invention is not limited thereto. Incidentally, in the following examples, % means mass%, and a molecular weight Mw is a weight-average molecular weight in terms of polystyrene by GPC measurement.

### [Synthesis Example 1-1]

To a mixture containing 120 g of methanol, 0.1 g of 10% nitric acid, and 60 g of deionized water, a mixture containing 30.6 g of Compound (101), 38.1 g of Compound (102), and 5.9 g of Compound (110) was added (mole ratio: 40/50/10) and maintained at 40°C for 12 hours to perform hydrolysis condensation. After completion of the reaction, 600 g of propylene glycol monoethyl ether (PGEE) was added thereto. Then, the water used for the hydrolysis condensation and by-produced alcohol were distilled off under reduced pressure. Thus, 440 g of a PGEE solution of a polysiloxane compound 1 was obtained (compound concentration: 10%). The molecular weight of the polysiloxane compound 1 was measured in terms of polystyrene and found Mw=2,900.

Synthesis Examples 1-2 to 1-18 were carried out under the same conditions as in Synthesis Example 1-1 by using monomers shown in Table 1 to obtain the target products as the polysiloxane compounds 2 to 18.

**[Table 1]**

| Synthesis Example | Charging amount of monomer (mol $) | | | | | | | | | | | | | MW |
|---|---|---|---|---|---|---|---|---|---|---|---|---|---|---|
| | 100 | 101 | 102 | 110 | 111 | 112 | 113 | 114 | 115 | 116 | 117 | 118 | 119 | |
| 1-1 | - | 40 | 50 | 10 | - | - | - | - | - | - | - | - | - | 2900 |
| 1-2 | 5 | 45 | 50 | - | - | - | - | - | - | - | - | - | - | 2300 |
| 1-3 | 5 | 40 | 50 | 2 | 3 | - | - | - | - | - | - | - | - | 2900 |
| 1-4 | - | 45 | 50 | - | - | 3 | - | - | 2 | - | - | - | - | 2600 |
| 1-5 | 5 | 40 | 50 | - | - | - | 2 | - | 3 | - | - | - | - | 2300 |
| 1-6 | 5 | 40 | 50 | - | - | - | - | 5 | - | - | - | - | - | 2500 |
| 1-7 | 5 | 40 | 50 | - | - | - | 2 | - | - | 3 | - | - | - | 2600 |
| 1-8 | 5 | 40 | 50 | - | - | - | - | - | - | 2 | 3 | - | - | 2300 |
| 1-9 | 5 | 40 | 50 | - | - | 2 | - | - | - | - | - | 3 | - | 2300 |
| 1-10 | 5 | 40 | 50 | - | - | - | - | - | - | - | - | 5 | - | 2300 |
| 1-11 | 5 | 40 | 50 | - | - | - | - | - | - | - | - | - | 5 | 2500 |
| 1-12 | 5 | 40 | 50 | - | - | - | - | - | - | - | - | 2 | 3 | 2100 |
| 1-13 | 20 | 10 | 70 | - | - | - | - | - | - | - | - | - | - | 2800 |
| 1-14 | 10 | 10 | 70 | 10 | - | - | - | - | - | - | - | - | - | 2500 |
| 1-15 | 10 | 10 | 70 | 4 | 6 | - | - | - | - | - | - | - | - | 2700 |
| 1-16 | 10 | 10 | 70 | - | - | 6 | - | - | 4 | - | - | - | - | 2500 |
| 1-17 | 10 | 10 | 70 | - | - | - | 4 | - | 6 | - | - | - | - | 2700 |
| 1-18 | 10 | 10 | 70 | - | - | - | - | 10 | - | - | - | - | - | 2700 |

PhSi(OCH₃)₃ · · · Compound (100)

CH₃Si(OCH₃)₃ · · · Compound (101)

Si(OCH₃)₄ · · · Compound (102)

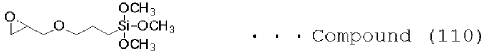

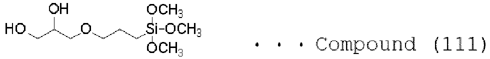

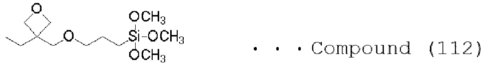

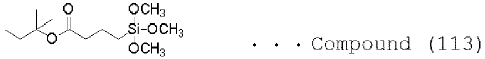

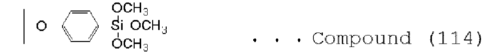

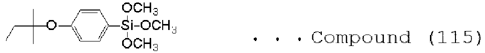

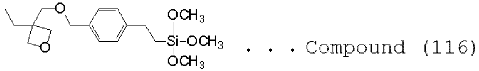

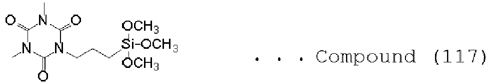

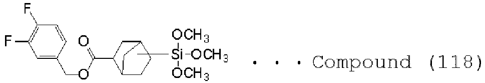

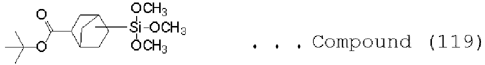

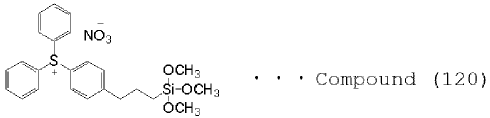

### [Synthesis Example of Crosslinking Catalyst] [Synthesis Example 2-1] Synthesis of Compound A (Intermediate 1)

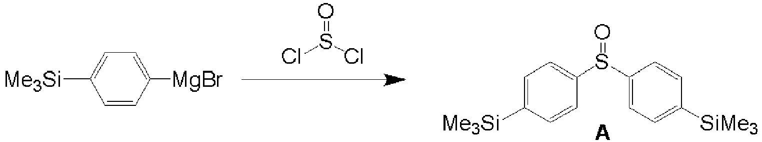

55 g of trimethylsilylmagnesium bromide was dissolved in 190 g of tetrahydrofuran, and this solution was added with a solution in which 14 g of thionyl chloride is dissolved in 35 g of tetrahydrofuran dropwise at 0°C. After aging at room temperature for 6 hours and quenching by adding 10% hydrochloric acid, the reaction solution was diluted with dichloromethane, washed with water, and water was further added to the organic layer three times to perform liquid separation. Thereafter, the obtained organic layer was concentrated under reduced pressure, the obtained oil was decanted with hexane, and the solid obtained after filtration was dried under reduced pressure to obtain 52 g of the target compound A as white crystals (yield 69%).

### [Synthesis Example 2-2] Synthesis of Compound B

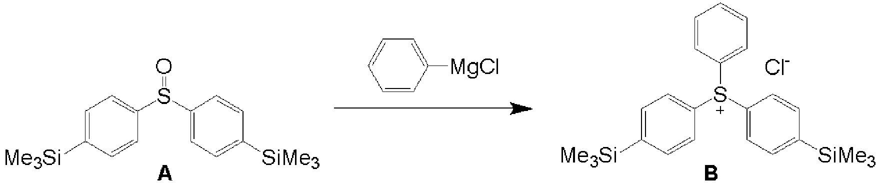

10 g of the compound A prepared in Synthesis Example 2-1 was dissolved in 50 g of dichloromethane, and 9 g of chlorotrimethylsilane was added dropwise thereto under ice cooling. Subsequently, a separately prepared Grignard reagent was added dropwise under ice-cooling. After aging at room temperature for 1.5 hours, an aqueous solution of ammonium chloride was added under ice-cooling, dichloromethane was added, the organic layer was separated, and water was further added to the organic layer five times to perform liquid separation. Thereafter, the obtained organic layer was concentrated under reduced pressure, the obtained oil was decanted with diisopropyl ether, and the solid obtained after filtration was dried under reduced pressure to obtain 12 g of the target compound B as white crystals (yield 92%).

### [Synthesis Example 2-3] Synthesis of Compound B'

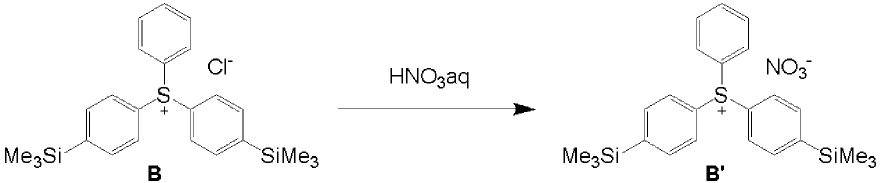

7 g of the compound B prepared in Synthesis Example 2-2 was dissolved in 100 g of dichloromethane, and 25 g of a 7% nitric acid aqueous solution was added thereto to separate an organic layer. The same operation was repeated two times. Water was further added to the organic layer four times to perform liquid separation. Thereafter, the obtained organic layer was concentrated under reduced pressure, the obtained oil was decanted with diisopropyl ether, and the solid obtained after filtration was dried under reduced pressure to obtain 7 g of the target compound B' as white crystals (yield 94%).

Synthesis Examples 2-4 to 2-13 were carried out under the same conditions as in Synthesis Examples 2-2 and 2-3 by using materials and acids shown in Tables 2 to obtain the target products respectively.

**[Table 2]**

| Synthesis Example | Reaction material | Target product (Yield) |
|---|---|---|
| 2-4 | Diphenylsulfide, CH₃SiPhMgBr | Compound (C) (88%) |
| 2-5 | Compound (A), CH₃SiPhMgBr, nitric acid | Compound (D) (96%) |
| 2-6 | Compound (A), FPhMgBr, p-toluenesulfonic acid | Compound (E) (90%) |
| 2-7 | Compound (A), CF₃PhMgBr, trifluoroacetic acid | Compound (F) (92%) |
| 2-8 | Compound (A), CH₃OPhMgBr, trifluorosulfonic acid | Compound (G) (89%) |
| 2-9 | Compound (A), Compound (H) | Compound (I) (85%) |
| 2-10 | Compound (A), Compound (J) | Compound (K) (87%) |
| 2-11 | Compound (L), CH₃SiPhMgBr, nitric acid | Compound (M) (89%) |
| 2-12 | Compound (A), Compound (N), nitric acid | Compound (O) (85%) |
| 2-13 | Compound (A), Compound (P), nitric acid | Compound (Q) (81%) |

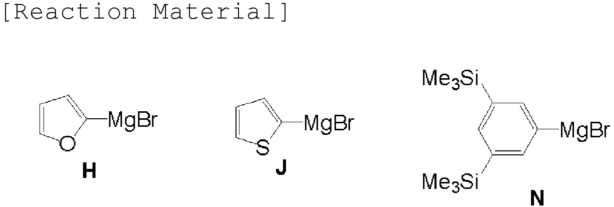

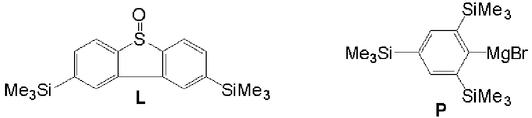

### [Target Product]

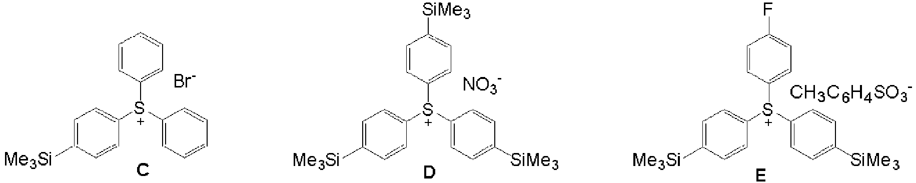

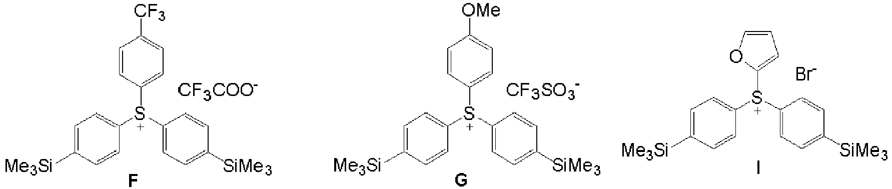

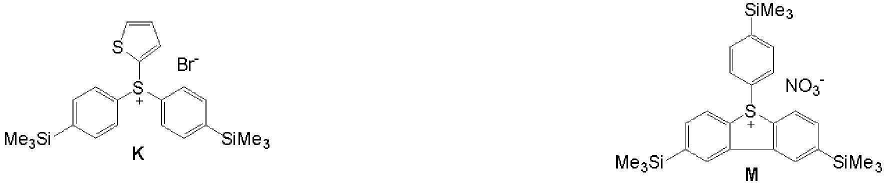

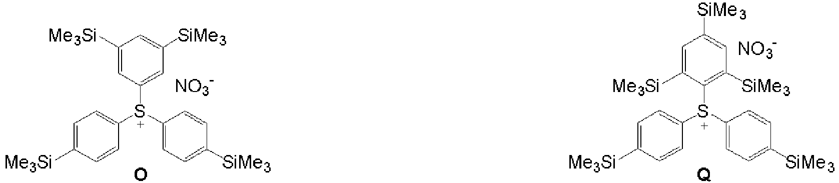

### [Comparative Synthesis Example 1-1] Synthesis of Sulfonium Salt-Containing Polysiloxane Compound R

To a mixture containing 120 g of methanol, 0.1 g of 10% nitric acid, and 60 g of deionized water, a mixture containing 61.3 g of Compound (101) and 24.4 g of Compound (120) was added and maintained at 40°C for 12 hours to perform hydrolysis condensation. After completion of the reaction, 300 g of propylene glycol monoethyl ether (PGEE) was added thereto, and then the water used for the hydrolysis condensation and by-produced alcohol were distilled off under reduced pressure to obtain 250 g of a PGEE solution of a sulfonium salt-containing polysiloxane compound R (compound concentration: 200). The molecular weight of the sulfonium salt-containing polysiloxane compound R was measured in terms of polystyrene and found Mw=2,000.

### [Examples 1-1 to 1-55 and Comparative Examples 1-1 to 1-4]

Polysiloxane compounds 1 to 18 obtained in the above Synthesis Examples, a silicon-containing sulfonium salt compound represented by the above general formula (A-1) as a crosslinking catalyst or a comparative crosslinking catalyst, an acid, a photoacid generator (PAG-1 to 7 listed in Table 6), a solvent, and water were mixed at the ratio shown in Tables 3 to 5. Each mixture was filtered through a 0.1 um fluororesin filter, prepared as a solution of a composition for forming a silicon-containing underlayer film, and set as Sol. 1 to 59 respectively.

**[Table 3]**

| No. | Polysiloxane (parts by mass) | Crosslinking catalyst (parts by mass) | Photo-acid generator (parts by mass) | Acid (parts by mass) | Solvent (parts by mass) | Water (parts by mass) |
|---|---|---|---|---|---|---|
| Sol. 1 | Compound 1 (1) | XL-1 (0.03) | None | maleic acid (0.01) | PGEE (100) | water (10) |
| Sol. 2 | Compound 1 (1) | XL-2 (0.03) | None | maleic acid (0.01) | PGEE (100) | water (10) |
| Sol. 3 | Compound 2 (1) | XL-3 (0.03) | None | maleic acid (0.01) | PGEE (100) | water (10) |
| Sol. 4 | Compound 2 (1) | XL-4 (0.03) | None | maleic acid (0.01) | PGEE (100) | water (10) |
| Sol. 5 | Compound 3 (1) | XL-5 (0.03) | None | maleic acid (0.01) | PGEE (100) | water (10) |
| Sol. 6 | Compound 3 (1) | XL-6 (0.03) | None | maleic acid (0.01) | PGEE (100) | water (10) |
| Sol. 7 | Compound 4 (1) | XL-7 (0.03) | None | maleic acid (0.01) | PGEE (100) | water (10) |
| Sol. 8 | Compound 4 (1) | XL-8 (0.03) | None | maleic acid (0.01) | PGEE (100) | water (10) |
| Sol. 9 | Compound 5 (1) | XL-9 (0.03) | None | maleic acid (0.01) | PGEE (100) | water (10) |
| Sol. 10 | Compound 5 (1) | XL-10 (0.03) | None | maleic acid (0.01) | PGEE (100) | water (10) |
| Sol. 11 | Compound 6 (1) | XL-11 (0.03) | None | maleic acid (0.01) | PGEE (100) | water (10) |
| Sol. 12 | Compound 6 (1) | XL-12 (0.03) | None | maleic acid (0.01) | PGEE (100) | water (10) |
| Sol. 13 | Compound 7 (1) | XL-1 (0.03) | None | maleic acid (0.01) | PGEE (100) | water (10) |
| Sol. 14 | Compound 7 (1) | XL-2 (0.03) | None | maleic acid (0.01) | PGEE (100) | water (10) |
| Sol. 15 | Compound 8 (1) | XL-3 (0.03) | None | maleic acid (0.01) | PGEE (100) | water (10) |
| Sol. 16 | Compound 9 (1) | XL-4 (0.03) | None | maleic acid (0.01) | PGEE (100) | water (10) |
| Sol. 17 | Compound 10 (1) | XL-5 (0.03) | None | maleic acid (0.01) | PGEE (100) | water (10) |
| Sol. 18 | Compound 11 (1) | XL-6 (0.03) | None | maleic acid (0.01) | PGEE (100) | water (10) |
| Sol. 19 | Compound 12 (1) | XL-7 (0.03) | None | maleic acid (0.01) | PGEE (100) | water (10) |
| Sol. 20 | Compound 13 (1) | XL-8 (0.03) | None | maleic acid (0.01) | PGEE (100) | water (10) |
| Sol. 21 | Compound 14 (1) | XL-9 (0.03) | None | maleic acid (0.01) | PGEE (100) | water (10) |
| Sol. 22 | Compound 15 (1) | XL-10 (0.03) | None | maleic acid (0.01) | PGEE (100) | water (10) |
| Sol. 23 | Compound 16 (1) | XL-10 (0.03) | None | maleic acid (0.01) | PGEE (100) | water (10) |
| Sol. 24 | Compound 17 (1) | XL-11 (0.03) | None | maleic acid (0.01) | PGEE (100) | water (10) |
| Sol. 25 | Compound 18 (1) | XL-12 (0.03) | None | maleic acid (0.01) | PGEE (100) | water (10) |
| Sol. 26 | Compound 1 (1) | XL-1 (0.03) | PAG-1 (0.01) | maleic acid (0.01) | PGEE (100) | water (10) |
| Sol. 27 | Compound 2 (1) | XL-2 (0.03) | PAG-2 (0.01) | maleic acid (0.01) | PGEE (100) | water (10) |
| Sol. 28 | Compound 3 (1) | XL-3 (0.03) | PAG-2 (0.01) | maleic acid (0.01) | PGEE (100) | water (10) |

**[Table 4]**

| No. | Polysiloxane (parts by mass) | Crosslinking catalyst (parts by mass) | Photo-acid generator (parts by mass) | Acid (parts by mass) | Solvent (parts by mass) | Water (parts by mass) |
|---|---|---|---|---|---|---|
| Sol. 29 | Compound 4 (1) | XL-4 (0.03) | PAG-3 (0.01) | maleic acid (0.01) | PGEE (100) | water (10) |
| Sol. 30 | Compound 5 (1) | XL-5 (0.03) | PAG-3 (0.01) | maleic acid (0.01) | PGEE (100) | water (10) |
| Sol. 31 | Compound 6 (1) | XL-6 (0.03) | PAG-4 (0.01) | maleic acid (0.01) | PGEE (100) | water (10) |
| Sol. 32 | Compound 7 (1) | XL-7 (0.03) | PAG-4 (0.01) | maleic acid (0.01) | PGEE (100) | water (10) |
| Sol. 33 | Compound 8 (1) | XL-8 (0.03) | PAG-5 (0.01) | maleic acid (0.01) | PGEE (100) | water (10) |
| Sol. 34 | Compound 9 (1) | XL-9 (0.03) | PAG-5 (0.01) | maleic acid (0.01) | PGEE (100) | water (10) |
| Sol. 35 | Compound 10 (1) | XL-10 (0.03) | PAG-6 (0.01) | maleic acid (0.01) | PGEE (100) | water (10) |
| Sol. 36 | Compound 11 (1) | XL-11 (0.03) | PAG-6 (0.01) | maleic acid (0.01) | PGEE (100) | water (10) |
| Sol. 37 | Compound 12 (1) | XL-12 (0.03) | PAG-7 (0.01) | maleic acid (0.01) | PGEE (100) | water (10) |
| Sol. 38 | Compound 13 (1) | XL-1 (0.03) | PAG-7 (0.01) | maleic acid (0.01) | PGEE (90) | water (10) |
| | | | | | GBL (10) | |
| Sol. 39 | Compound 14 (1) | XL-2 (0.03) | PAG-3 (0.01) | maleic acid (0.01) | PGEE (90) | water (10) |
| | | | | | DAA (10) | |
| Sol. 40 | Compound 15 (1) | XL-3 (0.03) | None | maleic acid (0.01) | PGEE (90) | water (10) |
| | | | | | PGME (10) | |
| Sol. 41 | Compound 16 (1) | XL-4 (0.03) | PAG-2 (0.01) | maleic acid (0.01) | PGEE (90) | water (10) |
| | | | | | GBL (10) | |
| Sol. 42 | Compound 17 (1) | XL-5 (0.03) | None | maleic acid (0.01) | PGEE (90) | water (10) |
| | | | | | DAA (10) | |
| Sol. 43 | Compound 18 (1) | XL-6 (0.03) | None | maleic acid (0.01) | PGEE (90) | water (10) |
| | | | | | PGME (10) | |
| Sol. 44 | Compound 1 (1) | XL-7 (0.03) | PAG-6 (0.01) | maleic acid (0.01) | PGEE (90) | water (10) |
| | | | | | GBL (10) | |
| Sol. 45 | Compound 2 (1) | XL-8 (0.03) | None | maleic acid (0.01) | PGEE (90) | water (10) |
| | | | | | DAA (10) | |
| Sol. 46 | Compound 3 (1) | XL-9 (0.03) | PAG-3 (0.01) | maleic acid (0.01) | PGEE (90) | water (10) |
| | | | | | PGME (10) | |
| Sol. 47 | Compound 4 (1) | XL-10 (0.03) | None | maleic acid (0.01) | PGEE (90) | water (10) |
| | | | | | PGME (10) | |
| Sol. 48 | Compound 5 (1) | XL-11 (0.03) | PAG-4 (0.01) | maleic acid (0.01) | PGEE (90) | water (10) |
| | | | | | GBL (10) | |
| Sol. 49 | Compound 6 (1) | XL-12 (0.03) | None | maleic acid (0.01) | PGEE (90) | water (10) |
| | | | | | DAA (10) | |
| Sol. 50 | Compound 4 (1) | XL-1 (0.015) | None | maleic acid (0.01) | PGEE (100) | water (10) |
| | | XL-2 (0.015) | | | | |
| Sol. 51 | Compound 5 (1) | XL-1 (0.015) | None | maleic acid (0.01) | PGEE (100) | water (10) |
| | | XL-4 (0.015) | | | | |

**[Table 5]**

| No. | Polysiloxane (parts by mass) | Crosslinking catalyst (parts by mass) | Photo-acid generator (parts by mass) | Acid (parts by mass) | Solvent (parts by mass) | Water (parts by mass) |
|---|---|---|---|---|---|---|
| Sol. 52 | Compound 6 (1) | XL-1 (0.015) | None | maleic acid (0.01) | PGEE (100) | water (10) |
| | | XL-10 (0.015) | | | | |
| Sol. 53 | Compound 7 (1) | XL-2 (0.015) | None | maleic acid (0.01) | PGEE (100) | water (10) |
| | | XL-12 (0.015) | | | | |
| Sol. 54 | Compound 8 (1) | XL-1 (0.015) | None | maleic acid (0.01) | PGEE (100) | water (10) |
| | | XL-13 (0.015) | | | | |
| Sol. 55 | Compound 9 (1) | XL-4 (0.015) | None | maleic acid (0.01) | PGEE (100) | water (10) |
| | | XL-13 (0.015) | | | | |
| Sol. 56 | Compound 1 (1) | XL-13 (0.03) | None | maleic acid (0.01) | PGEE (100) | water (10) |
| Sol. 57 | Compound 2 (1) | XL-14 (0.03) | None | maleic acid (0.01) | PGEE (100) | water (10) |
| Sol. 58 | Compound 3 (1) | XL-15 (0.03) | None | maleic acid (0.01) | PGEE (100) | water (10) |
| Sol. 59 | Compound 4 (1) | XL-16 (0.03) | None | maleic acid (0.01) | PGEE (100) | water (10) |

The used crosslinking catalysts are as follows.
- XL-1: Compound (B)
- XL-2: Compound (B')
- XL-3: Compound (C)
- XL-4: Compound (D)
- XL-5: Compound (E)
- XL-6: Compound (F)
- XL-7: Compound (G)
- XL-8: Compound (I)
- XL-9: Compound (K)
- XL-10: Compound (M)
- XL-11: Compound (O)
- XL-12: Compound (Q)
- XL-13: triphenylsulfonium nitrate
- XL-14: tetramethylammonium nitrate
- XL-15: tetraoctylammonium nitrate
- XL-16: sulfonium salt-containing polysiloxane compound (R)

The used solvents are as follow.
- PGEE: Propylene glycol monoethyl ether
- PGME: Propylene glycol monomethyl ether
- GBL: Gamma butyrlactone
- DAA: Diacetone alcohol

**[Table 6]**

| PAG | | PAG | |
|---|---|---|---|
| 1 | 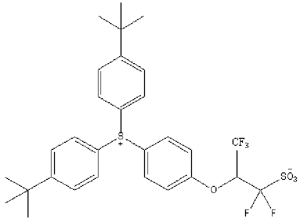 | 5 | 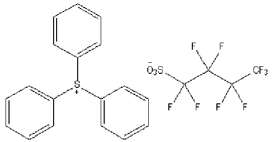 |
| 2 | 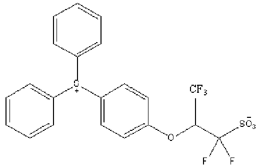 | 6 | 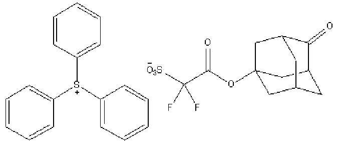 |
| 3 | 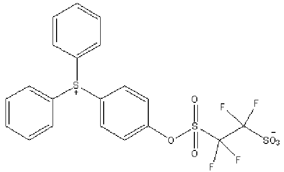 | 7 | 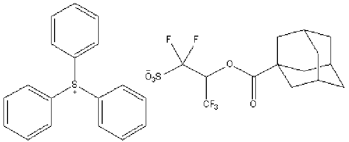 |
| 4 | 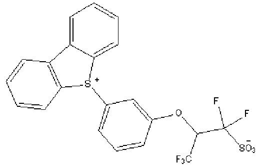 | | |

### (EUV Patterning Test)

A silicon wafer was spin-coated with one of the composition Sol. 1 to 59 for forming a silicon-containing resist underlayer film and heated at 220°C for 60 seconds. Thus, silicon-containing resist underlayer films having a film thickness of 25 nm were prepared on Si substrates as Films 1 to 59.

Subsequently, Films 1 to 59 were each spin-coated with a resist material in which the following components were dissolved at the ratio shown in Table 7 and prebaked at 105°C for 60 seconds using a hot plate to prepare resist upper layer films having a film thickness of 60 nm. The resultant was exposed using an EUV scanner NXE3300 manufactured by ASML (NA: 0.33, σ: 0.9/0.6, quadrupole illumination, with a mask having a hole pattern with a pitch of 46 nm and +20% bias (on-wafer size)) followed by PEB at 100°C for 60 seconds on the hot plate and development with a 2.38 mass% TMAH aqueous solution for 30 seconds to obtain a hole pattern with a dimension of 23 nm.

Using a CD-SEM (CG5000) manufactured by Hitachi High-Technologies Corporation, an exposure dose at which a hole dimension of 23 nm was formed was determined as sensitivity. Moreover, in this event, the dimensions of 50 holes were measured, from which the dimensional variation (CDU, 3σ) was determined. The results were shown in Tables 8 and 9.

The polymers, quenchers, sensitizers, surfactants, and organic solvents used as resist materials are as follows. 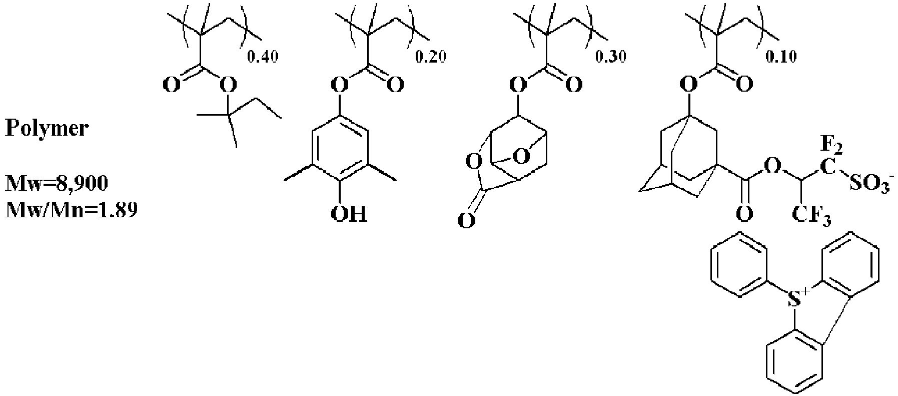 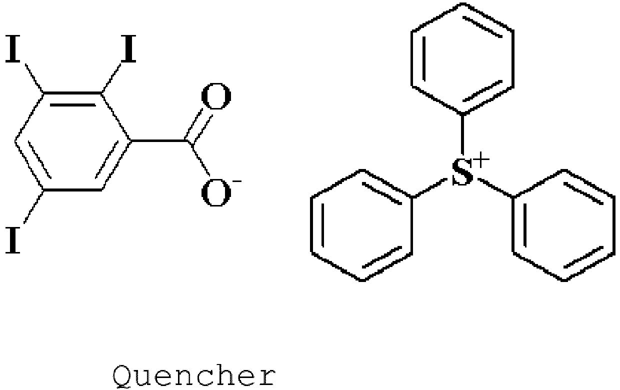 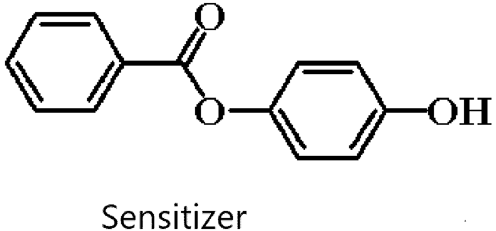
Surfactant: FC-4430, manufactured by 3M Corporation
PGMEA: propylene glycol monomethyl ether acetate
CyHO: cyclohexanone
PGME: propylene glycol monomethyl ether

**[Table 7]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

### (Etching Test of Silicon-Containing Resist Underlayer Film)

A silicon wafer was spin-coated with one of compositions Sol.1 to 59 for forming a silicon-containing resist underlayer film and heated at 220°C for 60 seconds to prepare silicon-containing resist underlayer films having a film thickness of 25 nm as Films 1 to 59 on a Si substrate.

These silicon-containing resist underlayer films each underwent an etching test under the following etching conditions.

### Etching Test with CHF₃/CF₄-based gas

Apparatus: Dry etching apparatus Telius SP, manufactured by Tokyo Electron Ltd.

### Etching Test:

| | |
|---|---|
| Chamber pressure: | 10Pa |
| Upper/Lower RF power: | 200 W/100 W |
| CHF₃ gas flow rate: | 50 ml/min |
| CF₄ gas flow rate: | 50 ml/min |
| N₂ gas flow rate: | 100 ml/min |
| Time: | 20 sec |

**[Table 8]**

| | Silicon-containing resist underlayer film | Sensitivity (mJ/cm²) | CDU (nm) | CHF₃/CF₄-based gas dry etching rate (nm/min) |
|---|---|---|---|---|
| Example 1-1 | Film 1 | 27 | 2.3 | 49.1 |
| Example 1-2 | Film 2 | 29 | 2.4 | 49.4 |
| Example 1-3 | Film 3 | 28 | 2.2 | 50.4 |
| Example 1-4 | Film 4 | 29 | 2.2 | 51.3 |
| Example 1-5 | Film 5 | 29 | 2.4 | 49.3 |
| Example 1-6 | Film 6 | 28 | 2.4 | 50.7 |
| Example 1-7 | Film 7 | 28 | 2.3 | 51.0 |
| Example 1-8 | Film 8 | 27 | 2.5 | 50.4 |
| Example 1-9 | Film 9 | 28 | 2.3 | 50.3 |
| Example 1-10 | Film 10 | 29 | 2.4 | 50.0 |
| Example 1-11 | Film 11 | 28 | 2.3 | 50.7 |
| Example 1-12 | Film 12 | 28 | 2.3 | 49.0 |
| Example 1-13 | Film 13 | 27 | 2.5 | 49.8 |
| Example 1-14 | Film 14 | 28 | 2.3 | 50. 9 |
| Example 1-15 | Film 15 | 27 | 2.5 | 50.0 |
| Example 1-16 | Film 16 | 28 | 2.3 | 49.7 |
| Example 1-17 | Film 17 | 29 | 2.3 | 49.2 |
| Example 1-18 | Film 18 | 27 | 2.5 | 51.1 |
| Example 1-19 | Film 19 | 27 | 2.2 | 51.0 |

**[Table 9]**

| | Silicon-containing resist underlayer film | Sensitivity (mJ/cm²) | CDU (nm) | CHF₃/CF₄-based gas dry etching rate (nm/min) |
|---|---|---|---|---|
| Example 1-20 | Film 20 | 27 | 2.3 | 49.8 |
| Example 1-21 | Film 21 | 28 | 2.4 | 51.5 |
| Example 1-22 | Film 22 | 29 | 2.3 | 50.0 |
| Example 1-23 | Film 23 | 29 | 2.3 | 49.9 |
| Example 1-24 | Film 24 | 29 | 2.2 | 50.8 |
| Example 1-25 | Film 25 | 27 | 2.5 | 51.4 |
| Example 1-26 | Film 26 | 29 | 2.4 | 50.6 |
| Example 1-27 | Film 27 | 28 | 2.3 | 50. 9 |
| Example 1-28 | Film 28 | 27 | 2.4 | 49.2 |
| Example 1-29 | Film 29 | 28 | 2.4 | 50.0 |
| Example 1-30 | Film 30 | 27 | 2.3 | 51.4 |
| Example 1-31 | Film 31 | 29 | 2.3 | 49.1 |
| Example 1-32 | Film 32 | 28 | 2.2 | 51.2 |
| Example 1-33 | Film 33 | 28 | 2.3 | 50.7 |
| Example 1-34 | Film 34 | 28 | 2.3 | 49.5 |
| Example 1-35 | Film 35 | 29 | 2.2 | 49.6 |
| Example 1-36 | Film 36 | 28 | 2.2 | 51.1 |
| Example 1-37 | Film 37 | 29 | 2.4 | 49.2 |
| Example 1-38 | Film 38 | 29 | 2.2 | 49.6 |
| Example 1-39 | Film 39 | 29 | 2.2 | 50.8 |
| Example 1-40 | Film 40 | 27 | 2.2 | 49.8 |
| Example 1-41 | Film 41 | 28 | 2.3 | 49.3 |
| Example 1-42 | Film 42 | 29 | 2.4 | 49.0 |
| Example 1-43 | Film 43 | 28 | 2.4 | 51.3 |
| Example 1-44 | Film 44 | 27 | 2.3 | 49.8 |
| Example 1-45 | Film 45 | 28 | 2.3 | 50.6 |
| Example 1-46 | Film 46 | 29 | 2.4 | 50.6 |
| Example 1-47 | Film 47 | 29 | 2.4 | 50.3 |
| Example 1-48 | Film 48 | 28 | 2.2 | 51.0 |
| Example 1-49 | Film 49 | 28 | 2.4 | 49.3 |
| Example 1-50 | Film 50 | 29 | 2.3 | 51.4 |
| Example 1-51 | Film 51 | 27 | 2.2 | 49.3 |
| Example 1-52 | Film 52 | 28 | 2.2 | 50.1 |
| Example 1-53 | Film 53 | 28 | 2.3 | 49.5 |
| Example 1-54 | Film 54 | 27 | 2.3 | 48.5 |
| Example 1-55 | Film 55 | 28 | 2.2 | 48.6 |
| Comparative example 1-1 | Film 56 | 29 | 3.1 | 47.0 |
| Comparative example 1-2 | Film 57 | 29 | 3.1 | 47.0 |
| Comparative example 1-3 | Film 58 | 28 | 3 | 47.1 |
| Comparative example 1-4 | Film 59 | 29 | 3.1 | 49.4 |

As shown in Comparative Examples 1-1 to 1-4 in Tables 8 and 9, Films 56 to 59 that did not contain the inventive silicon-containing sulfonium salt compound represented by the above general formula (A-1) as a crosslinking catalyst was confirmed to have CDU deteriorated or not to have a sufficient etching rate. On the other hand, as shown in Examples 1-1 to 1-55, Films 1 to 55 that contain the inventive silicon-containing sulfonium salt compound represented by the above general formula (A-1) as a crosslinking catalyst was found to have a high affinity with a silicon polymer to suppress its diffusion into the upper resist layer, and thus have an effect of improving CDU and a sufficient etching rate.

### [Examples 2-1 to 2-14 and Comparative Examples 2-1 to 2-4]

### (ArF Patterning Test)

On a silicon wafer, a spin-on carbon film ODL-102 (carbon content: 89 mass%) manufactured by Shin-Etsu Chemical CO., Ltd. was formed to have a film thickness of 200 nm. The spin-on carbon film was coated with one of the compositions (Sol. 1 to 4, 10 to 12, 26 to 29, 50 to 52, and 56 to 59) for forming a silicon-containing resist underlayer film, and heated at 220°C for 60 seconds. In this way, silicon-containing resist underlayer films having a film thickness of 20 nm were prepared as Films 1 to 4, 10 to 12, 26 to 29, 50 to 52, and 56 to 59.

Subsequently, the silicon-containing resist underlayer film was coated with an ArF resist solution (PR-1) for positive development shown in Table 10 and baked at 110°C for 60 seconds to form a photoresist film having a film thickness of 100 nm. Further, the photoresist film was coated with a liquid immersion top coat material (TC-1) shown in Table 11 and baked at 90°C for 60 seconds to form a top coat having a film thickness of 50 nm.

Then, these films were exposed by using an ArF liquid-immersion exposure apparatus (XT-19001 manufactured by ASML, NA: 1.35, σ: 0.97/0.77, 35° s-polarized dipole illumination), baked (PEB) at 100°C for 60 seconds, and developed with a 2.38 mass% aqueous solution of tetramethylammonium hydroxide (TMAH) for 30 seconds to obtain a positive line-and-space pattern of 1:1 with 40 nm. Regarding dimension of these patterns, LWR was observed by using an SEM (CG5000) manufactured by Hitachi High-Technologies Corporation. The results are shown in Table 12.

**[Table 10]**

| | Polymer (parts by mass) | Acid generator (parts by mass) | Base (parts by mass) | Surfactant (parts by mass) | Solvent (parts by mass) |
|---|---|---|---|---|---|
| PR-1 | ArF resist polymer 1 (100) | PAG-A (7.0) | Quencher (1.0) | FC-4430 (0.2) | PGMEA (2,500) |

### ArF resist polymer 1 [molecular weight (Mw)=7,800, dispersity (Mw/Mn)=1.78]

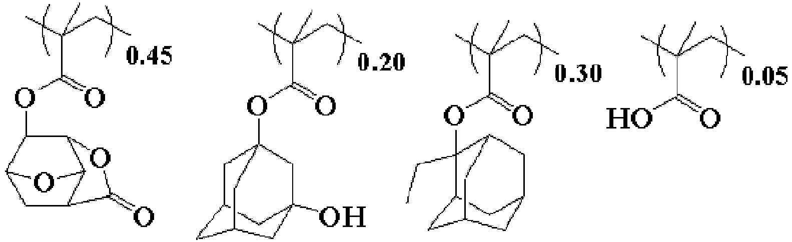

### Acid generator: PAG-A

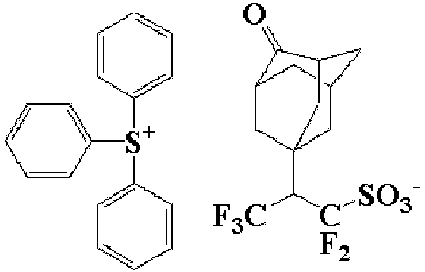

### Base: Quencher

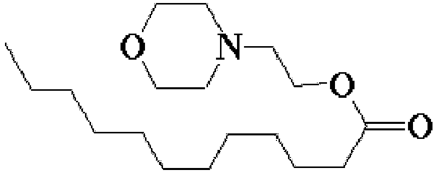

### Surfactant: FC-4430, manufactured by 3M Corporation

**[Table 11]**

| | Polymer (parts by mass) | Organic solvent (parts by mass) |
|---|---|---|
| TC-1 | Top coat polymer (100) | diisoamyl ether (2700) |
| | | 2-methyl-1-butanol (270) |

### Top coat polymer [molecular weight (Mw)=8,800, dispersity (Mw/Mn)=1.69]

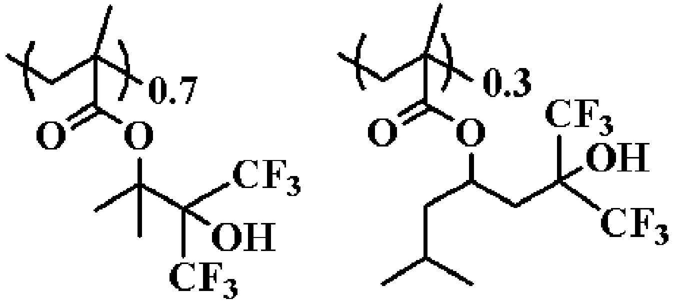

**[Table 12]**

| | Silicon-containing resist underlayer film | LWR |
|---|---|---|
| Example 2-1 | Film 1 | 2.1 |
| Example 2-2 | Film 2 | 2.0 |
| Example 2-3 | Film 3 | 2.0 |
| Example 2-4 | Film 4 | 2.0 |
| Example 2-5 | Film 10 | 2.1 |
| Example 2-6 | Film 11 | 2.1 |
| Example 2-7 | Film 12 | 2.2 |
| Example 2-8 | Film 26 | 2.1 |
| Example 2-9 | Film 27 | 2.0 |
| Example 2-10 | Film 28 | 2.1 |
| Example 2-11 | Film 29 | 2.1 |
| Example 2-12 | Film 50 | 2.2 |
| Example 2-13 | Film 51 | 2.2 |
| Example 2-14 | Film 52 | 2.1 |
| Comparative example 2-1 | Film 56 | 3.5 |
| Comparative example 2-2 | Film 57 | 3.6 |
| Comparative example 2-3 | Film 58 | 3.2 |
| Comparative example 2-4 | Film 59 | 3.4 |

As shown in Examples 2-1 to 2-14 in Table 12, it was confirmed that Films 1 to 4, 10 to 12, 26 to 29, and 50 to 52 containing the inventive silicon-containing sulfonium salt compound represented by the above general formula (A-1) as a crosslinking catalyst had a high affinity with a silicon polymer to suppress its diffusion into the upper resist layer, and thus exhibited an effect of improving LWR.

On the other hand, as shown in Comparative Examples 2-1 to 2-4, Films 56 to 59 not containing the inventive silicon-containing sulfonium salt compound represented by the above general formula (A-1) had LWR deteriorated.

The present description includes the following embodiments.
[1]: A silicon-containing sulfonium salt compound represented by the following general formula (A-1), 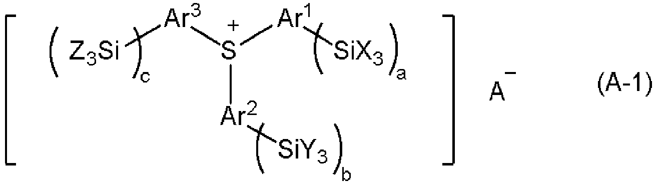 wherein, Ar¹, Ar², and Ar³ are each independently an aromatic group having 6 to 20 carbon atoms and optionally containing a substituent, or a heteroaromatic group having 4 to 20 carbon atoms and optionally containing a substituent, and any two or more selected from the group consisting of Ar¹, Ar², and Ar³ may be bonded with each other to form a ring together with a sulfur atom in the formula; "a", "b", and "c" each independently are an integer of 0 to 3 and satisfy 1≤a+b+c≤9; X, Y, and Z represent a monovalent organic group having 1 to 14 carbon atoms, and may be the same or different from each other; and A⁻ represents an organic or inorganic anion that serves as a counter ion of a sulfonium cation.
[2]: A composition for forming a silicon-containing resist underlayer film, comprising; the silicon-containing sulfonium salt compound according to the above [1]; and a thermally crosslinkable polysiloxane.
[3]: The composition for forming a silicon-containing resist underlayer film according to the above [2], wherein the thermally crosslinkable polysiloxane contains any one or more of a repeating unit represented by the following general formula (Sx-1), a repeating unit represented by the following general formula (Sx-2), or a partial structure represented by the following general formula (Sx-3), 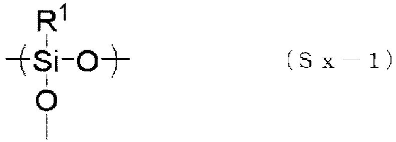 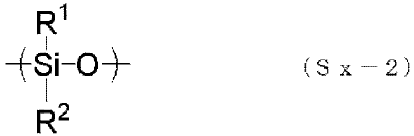 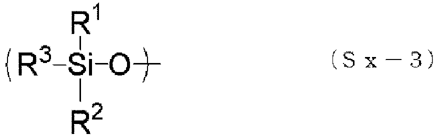 wherein R¹, R², and R³ are a monovalent organic group having 1 to 30 carbon atoms, which may be the same or different from each other.
[4]: The composition for forming a silicon-containing resist underlayer film according to the above [2] or [3], further comprising an acid generator.
[5]: The composition for forming a silicon-containing resist underlayer film according to the above [4], wherein the acid generator is a photoacid generator that generates an acid by action of a high-energy beam.
[6]: A patterning process for forming a pattern in a body to be processed, comprising the steps of:
   forming an organic film on a body to be processed by using a coating-type material for an organic film;
   forming a silicon-containing resist underlayer film on the organic film by using the composition for forming a silicon-containing resist underlayer film of any one of the above [2] to [5];
   forming a resist upper layer film on the silicon-containing resist underlayer film by using a composition for a resist upper layer film containing a photoresist composition;
   forming a circuit pattern in the resist upper layer film;
   transferring the pattern to the silicon-containing resist underlayer film by etching while using the resist upper layer film having the formed circuit pattern as a mask;
   transferring the pattern to the organic film by etching while using the silicon-containing resist underlayer film having the transferred pattern as a mask; and
   transferring the pattern to the body to be processed by etching while using the organic film having the transferred pattern as a mask.
[7]: A patterning process for forming a pattern in a body to be processed, comprising the steps of:
   forming a hard mask on a body to be processed by a CVD method;
   forming a silicon-containing resist underlayer film on the hard mask by using the composition for forming a silicon-containing resist underlayer film according to any one of the above [2] to [5];
   forming a resist upper layer film on the silicon-containing resist underlayer film by using a composition for a resist upper layer film containing a photoresist composition;
   forming a circuit pattern in the resist upper layer film;
   transferring the pattern to the silicon-containing resist underlayer film by etching while using the resist upper layer film having the formed circuit pattern as a mask;
   transferring the pattern to the hard mask by dry etching while using the silicon-containing resist underlayer film having the transferred pattern as a mask; and
   transferring the pattern to the body to be processed by dry etching while using the hard mask having the transferred pattern as a mask.
[8]: The patterning process according to the above [6] or [7], wherein a circuit pattern is formed in the resist upper layer film by photolithography using a light having a wavelength of 10 nm or more and 300 nm or less, direct drawing by an electron beam, nanoimprinting, or a combination thereof.
[9]: The patterning process according to any one of the above [6] to [8], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[10]: The patterning process according to the above [9], wherein the metal to be used is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A silicon-containing sulfonium salt compound represented by the following general formula (A-1), 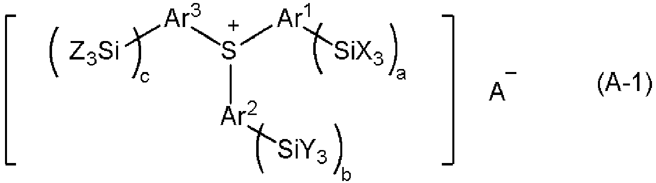 wherein, Ar¹, Ar², and Ar³ are each independently an aromatic group having 6 to 20 carbon atoms and optionally containing a substituent, or a heteroaromatic group having 4 to 20 carbon atoms and optionally containing a substituent, and any two or more selected from the group consisting of Ar¹, Ar², and Ar³ may be bonded with each other to form a ring together with a sulfur atom in the formula; "a", "b", and "c" each independently are an integer of 0 to 3 and satisfy 1≤a+b+c≤9; X, Y, and Z represent a monovalent organic group having 1 to 14 carbon atoms, and may be the same or different from each other; and A⁻ represents an organic or inorganic anion that serves as a counter ion of a sulfonium cation.

2. A composition for forming a silicon-containing resist underlayer film, comprising; the silicon-containing sulfonium salt compound according to claim 1; and a thermally crosslinkable polysiloxane.

3. The composition for forming a silicon-containing resist underlayer film according to claim 2, wherein the thermally crosslinkable polysiloxane contains any one or more of a repeating unit represented by the following general formula (Sx-1), a repeating unit represented by the following general formula (Sx-2), or a partial structure represented by the following general formula (Sx-3), 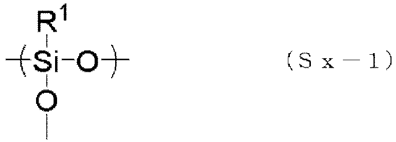 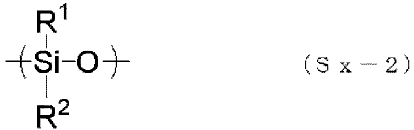 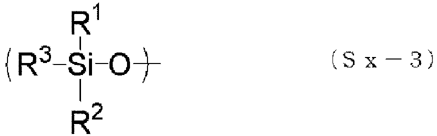 wherein R¹, R², and R³ are a monovalent organic group having 1 to 30 carbon atoms, which may be the same or different from each other.

4. The composition for forming a silicon-containing resist underlayer film according to claim 2 or 3, further comprising an acid generator.

5. The composition for forming a silicon-containing resist underlayer film according to claim 4, wherein the acid generator is a photoacid generator that generates an acid by action of a high-energy beam.

6. A patterning process for forming a pattern in a body to be processed, comprising the steps of:
forming an organic film on a body to be processed by using a coating-type material for an organic film;
forming a silicon-containing resist underlayer film on the organic film by using the composition for forming a silicon-containing resist underlayer film according to any one of claims 2 to 5;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask;
transferring the pattern to the organic film by etching while using the silicon-containing resist underlayer film having the transferred pattern as a mask; and
transferring the pattern to the body to be processed by etching while using the organic film having the transferred pattern as a mask.

7. A patterning process for forming a pattern in a body to be processed, comprising the steps of:
forming a hard mask on a body to be processed by a CVD method;
forming a silicon-containing resist underlayer film on the hard mask by using the composition for forming a silicon-containing resist underlayer film according to any one of claims 2 to 5;
forming a resist upper layer film on the silicon-containing resist underlayer film by using a composition for a resist upper layer film containing a photoresist composition;
forming a circuit pattern in the resist upper layer film;
transferring the pattern to the silicon-containing resist underlayer film by etching while using the resist upper layer film having the formed circuit pattern as a mask;
transferring the pattern to the hard mask by dry etching while using the silicon-containing resist underlayer film having the transferred pattern as a mask; and
transferring the pattern to the body to be processed by dry etching while using the hard mask having the transferred pattern as a mask.

8. The patterning process according to claim 6 or 7, wherein a circuit pattern is formed in the resist upper layer film by photolithography using a light having a wavelength of 10 nm or more and 300 nm or less, direct drawing by an electron beam, nanoimprinting, or a combination thereof.

9. The patterning process according to any one of claims 6 to 8, wherein the body to be processed is a semiconductor device substrate or the semiconductor device substrate coated with any of a metal film, a metal carbide film, a metal oxide film, a metal nitride film, a metal oxycarbide film, and a metal oxynitride film.

10. The patterning process according to claim 9, wherein the metal to be used is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.
